# EUROPEAN PATENT APPLICATION

(11) **EP 4 675 356 A1**
(43) Date of publication of application: **07.01.2026**
(21) Application number: 25183722.5
(22) Date of filing: 18.06.2025
(51) Int. Cl.: G03F 7/09, C09D 171/00, G03F 7/11

(54) **POLYMER FOR COMPOSITION FOR FORMING ORGANIC FILM, METHOD FOR MANUFACTURING THE SAME, COMPOSITION FOR FORMING ORGANIC FILM CONTAINING THE POLYMER, METHOD FOR FORMING ORGANIC FILM USING THE COMPOSITION, AND PATTERNING PROCESS USING THE COMPOSITION**

(30) Priority: 26.06.2024 JP 2024102562
(71) Applicant: SHIN-ETSU CHEMICAL CO., LTD., Tokyo 1000005 (JP)
(72) Inventor: SAWAMURA, Takashi, Niigata (JP); IMATA, Tomohiro, Niigata (JP); MATSUBARA, Satoshi, Niigata (JP)
(74) Representative: Schicker, Silvia

(57) **Abstract**

The present invention provides a composition for forming an organic film, containing: a resin and/or compound (A) for forming an organic film; a polymer (B) not containing a halogen atom and containing a repeating unit represented by the following formula (1) and a repeating unit represented by the following formula (1'); and a solvent (C), where R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1. This can provide a composition for forming an organic film that makes it possible to form a film excellent in coating property such as coating defects, such as pinholes on a substrate (wafer), film-formability (inplane uniformity), and filling property, the composition not containing a fluorine atom and containing a particular polymer. Furthermore, the present invention can provide a method for forming an organic film using the composition for forming an organic film, a patterning process using the composition for forming an organic film, and the polymer.

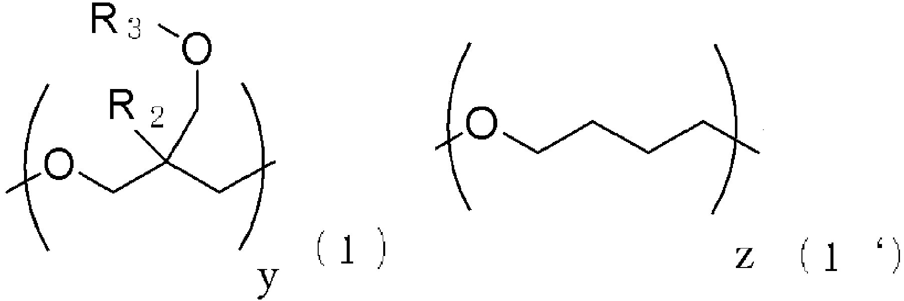

## Description

### TECHNICAL FIELD

The present invention relates to: a polymer for a composition for forming an organic film; a method for manufacturing the same; a composition for forming an organic film, containing the polymer; a method for forming an organic film, using the composition; and a patterning process using the composition.

Furthermore, the present invention relates to: a composition for forming an organic film with which it is possible to form an organic film for a multilayer resist for fine processing in manufacturing a semiconductor device or the like, or an organic film for planarization in manufacturing a semiconductor device or the like; a method for forming an organic film, using the composition; a patterning process using the composition; and a polymer to be contained in the composition.

### BACKGROUND ART

As LSIs advance toward higher integration and higher processing speed, miniaturization of pattern rule is progressing rapidly. This is because the spread of high-speed communication of 5 G and artificial intelligence (AI) has progressed, and high-performance devices for processing these are needed. As a cutting-edge technology for miniaturization, 5-nm node devices have been mass-produced by extreme ultraviolet ray (EUV) lithography at a wavelength of 13.5 nm. Furthermore, studies are also in progress on employing EUV lithography in next-generation 3-nm node and the following-generation 2-nm node devices.

In a monolayer resist method, which is employed as a typical resist patterning process, as the thinning of resist patterns progresses as described above, pattern formation becomes difficult, and it is known that, as a fine pattern processing method, a multilayer resist method, in which a pattern is formed by laminating films having different dry etching properties for forming a pattern with a high aspect ratio on an uneven substrate, is excellent. There has been developed and put to practical use, a three-layer resist method in which a photoresist layer made of an organic photosensitive polymer used in a monolayer resist method is combined with a middle layer made of a silicon-based polymer or a silicon-based CVD film, and an underlayer made of an organic polymer (Patent Document 1).

In the three-layer resist method, for example, an organic film made of a novolak or the like is formed uniformly as a resist underlayer film on a substrate to be processed; a silicon-containing film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in a novolak film (resist middle layer film) having sufficient dry etching resistance for processing.

Many techniques are already known (e.g. Patent Documents 2 and 3) regarding organic underlayer films like the organic underlayer film described above. However, in association with recent progress in miniaturization, the need for excellent filling property in addition to dry etching property is rising. There is a demand for an organic underlayer film material that enables uniform film formation even on an underlying substrate to be processed having a complex form or any material, and that has a filling property that allows a required pattern to be filled without gaps.

When a semiconductor substrate or the like is manufactured, the above-described organic underlayer film is formed using a coater/developer that can perform treatments such as spin-coating process, EBR process, and baking process. An EBR (Edge Bead Removal) process is a process of removing, after forming a film on a substrate (wafer) by spin-coating, the film on the edge of the substrate with a remover for the purpose of preventing the contamination of a substrate-conveying arm of the coater/developer. Examples of a remover used in EBR processes include a mixed solution of propylene glycol monomethyl ether acetate and propylene glycol monomethyl ether (30 mass%:70 mass%), and such removers are widely used in EBR processes of resist films and resist middle layer films (silicon-containing middle layer films and organic underlayer films).

Due to the effect of a remover in an EBR process, a state where a peripheral portion of an organic underlayer film has a thick film thickness (a hump) occurs in some cases. In the above-described dry etching step at the time of substrate processing, a hump causes defects, and therefore, an organic underlayer film in which a hump is suppressed is desired.

As well as organic underlayer films, a resist material used in photolithography using the organic photosensitive polymer described above is applied by a method such as spin-coating with a solution in the same manner as the organic underlayer film, and the solvent is evaporated by baking to form a film. In the same manner as the organic underlayer film, the film thickness after baking is required to be uniform and flat, and demands for the uniformity and flatness are becoming stricter year by year.

In recent years, there are demands for thick resist films for use in 3D-NAND memory, and even higher flatness is required. As the film thickness becomes thicker, it becomes more difficult to achieve flatness within the film. Meanwhile, along with progress in miniaturization, the thinning of films is progressing, and in this case, the risk of pinhole defects and so forth occurring is increasing.

Examples of film materials using organic matter used as semiconductor-processing materials are described above, but obtaining a material that forms a film with in-plane uniformity of film thickness and without pinholes is also industrially greatly advantageous in film-formation materials that do not use organic matter.

Here, in recent years, the effect of perfluoroalkyl compounds (PFAS) on health has been pointed out, and there is a movement in the European REACH to restrict the production and sale of PFAS compounds. There are many uses for perfluoroalkyl compounds, and because of properties, such as water and oil repellency, resistance to heat, resistance to chemicals, and not absorbing light, originating from the structure, perfluoroalkyl compounds are used for a wide range of uses, for example, water repellents, surface treatment agents, emulsifiers, fire extinguishers, and coating agents. Therefore, a demand for the development of an alternative material not having a PFAS structure has become urgent.

As examples of materials containing a perfluoroalkyl compound described above, surfactants having a fluoroalkyl group or a silicone chain has a high effect of lowering surface tension, and in particular, fluoroalkyl-group-based surfactants, which carry little risk of particles derived from silicon being generated after dry ashing of a resist film, are widely used (Patent Documents 3 and 4). Furthermore, fluorine-based surfactants are applied not only for resist materials but also for top coats to be formed on an upper layer resist and underlayer antireflective films to be formed on an underlayer resist (Patent Document 5).

From the viewpoint of stricter restriction in the future, it is necessary to use materials that do not apply to the PFAS restriction. For example, as the above-described surfactants, surfactants having trifluoromethoxy groups or pentafluorosulfanyl groups and usage thereof are proposed (Patent Document 6). Meanwhile, in the field of resist materials, resist materials containing photo-acid generators etc. are also proposed (Patent Document 7). Furthermore, surfactants containing no fluorine are proposed (Patent Document 8).

### CITATION LIST

### PATENT LITERATURE

Patent Document 1: JP 2004-205685 A
Patent Document 2: JP 4355943 B2
Patent Document 3: JP H6-186735 A
Patent Document 4: JP H6-214380 A
Patent Document 5: JP 2010-139822 A
Patent Document 6: JP 2008-526792 A
Patent Document 7: WO 2023-223624 A1
Patent Document 8: WO 2022-073921 A1

### SUMMARY OF INVENTION

### TECHNICAL PROBLEM

The present invention has been made in view of the above-described circumstances, and provides a polymer containing no fluorine atoms. By using an organic film material composition containing the polymer, it is possible to form a film excellent in coating property such as coating defects, such as pinholes on a substrate (wafer), film-formability (in-plane uniformity), and filling property. Furthermore, the present invention makes it possible to provide an organic film which is excellent in process margin and in which humps have been suppressed when used as an organic underlayer film for a multilayer resist by using the composition for forming an organic film as an organic underlayer film material, and an object of the present invention is to provide a method for forming an organic film, using the composition for forming an organic film, and patterning processes using the composition for forming an organic film. Furthermore, an object of the above-described present invention is to provide a material for forming a film that does not come under the classification of perfluoroalkyl compounds (PFAS) and provide a material for forming a film with little environmental load.

### SOLUTION TO PROBLEM

To achieve the object, the present invention provides the following.

The present invention provides a composition for forming an organic film, comprising: a resin and/or compound (A) for forming an organic film; a polymer (B) not containing a halogen atom and containing a repeating unit represented by the following formula (1) and a repeating unit represented by the following formula (1'); and a solvent (C), 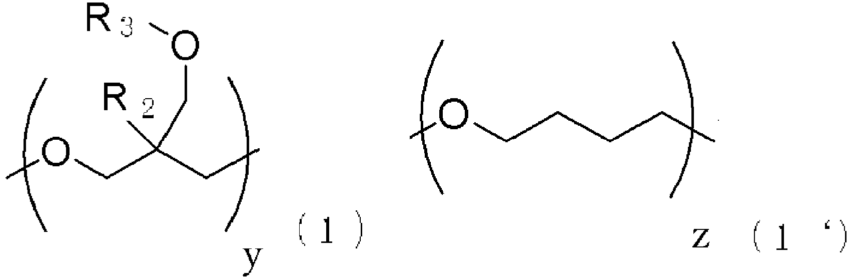 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.

Such a composition for forming an organic film makes it possible to form an organic film having excellent in-plane uniformity and excellent filling property and in which the formation of humps due to the effect of a remover in an EBR process has been suppressed. Furthermore, the alkyl group structures of R₂ and R₃ in the formula (1) provides a suitable contact angle of the organic film surface, and it is possible to achieve a composition for forming an organic film excellent in the coating property of a silicon-containing middle layer film.

The polymer (B) is preferably represented by the following formula (2), 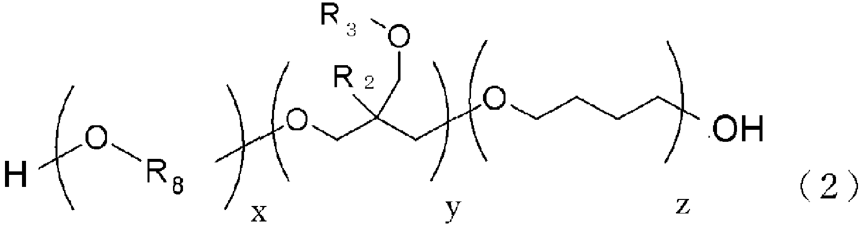 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.

Such a polymer, extended in both directions, can be provided with enhanced uniformity, and therefore, when the polymer is contained in a composition for forming an organic film, it is possible to form an organic film having excellent in-plane uniformity and excellent filling property and in which the formation of humps due to the effect of a remover in an EBR process has been suppressed.

It is preferable that, in the polymer represented by the formula (2), the "x", "y", and "z" in the formula each independently satisfy 0 < x < 1, 0 < y < 1, and 0 < z < 1, provided that x+y+z = 1.

The polymer (B) is preferably represented by the following formula (3), 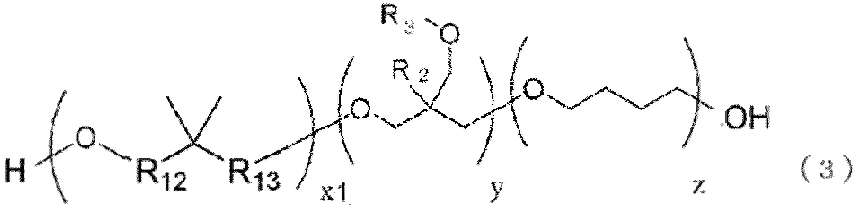 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.

A composition for forming an organic film containing such a compound can be provided with improved film-formability at the time of application because alkyl groups and hydroxy groups are contained. Moreover, there is no risk of the in-plane uniformity of the film being degraded by a decomposition product generated during baking, and there is no risk of insoluble matter being formed by a reaction between decomposition products or the like. Therefore, there are no risks of process margin being narrowed when the composition is used for an organic film, or of apparatus contamination, inconvenience, etc. occurring.

The "x", "y", and "z" in the general formula (2) preferably satisfy x+y+z = 1, z < x < y, and z+x < y.

The polymer (B) preferably has a weight-average molecular weight of 1000 to 30000.

When the weight-average molecular weight is in such a range, it is possible to form an organic film excellent in film-formability and filling property.

The polymer (B) is preferably contained in an amount of 0.01 parts by mass to 5 parts by mass based on 100 parts by mass of the resin and/or compound (A) for forming an organic film.

When the composition for forming an organic film contains the polymer in such an amount, a formed organic film has better in-plane uniformity.

The present invention provides a method for manufacturing a polymer not containing a halogen atom and containing a repeating unit represented by the following formula (1) and a repeating unit represented by the following formula (1'), the method comprising ring-opening polymerization of an oxetane-ring-containing compound represented by the following formula (4), using a Lewis acid cationic polymerization catalyst and tetrahydrofuran, 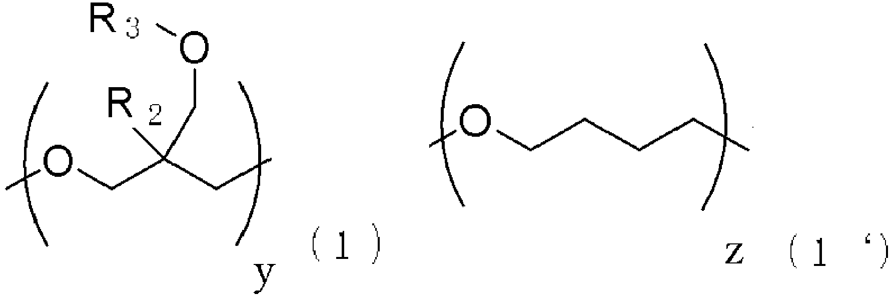 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1, 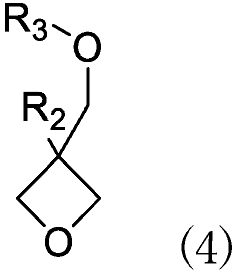 wherein R₂ and R₃ are as defined in the formula (1).

According to such a manufacturing method, the inventive polymer for a composition for forming an organic film can be manufactured suitably.

The present invention provides a method for forming an organic film to be used in a manufacturing process of a semiconductor device, the method comprising:
spin-coating a substrate to be processed with the above-described composition for forming an organic film; and
forming a cured film by heating the substrate coated with the composition for forming an organic film at a temperature of 100°C or higher and 600°C or lower for 10 to 600 seconds.

Such a method for forming an organic film is particularly suitable for filling a pattern having a complicated shape on a substrate to be processed by spin-coating, forming an organic film having excellent in-plane uniformity, and removing the organic film on an edge portion while suppressing humps in an EBR process.

The present invention also provides a patterning process comprising:
forming an organic film on a body to be processed by using the above-described composition for forming an organic film;
forming a resist middle layer film on the organic film by using a resist middle layer film material containing a silicon atom;
forming a resist upper layer film on the resist middle layer film by using a resist upper layer film material comprising a photoresist composition;
forming a circuit pattern in the resist upper layer film;
transferring the pattern to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming a resist middle layer film on the organic film by using a resist middle layer film material containing a silicon atom;
forming an organic antireflective film or an adhesive film on the resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

As described, the inventive composition for forming an organic film can be used suitably in various patterning processes such as a three-layer resist process using a silicon-containing resist middle layer film or an inorganic hard mask, or a four-layer resist process using an organic antireflective film or an adhesive film in addition to these films. Furthermore, according to the inventive patterning processes as described, the circuit pattern of the resist upper layer film can be transferred to and formed in the body to be processed with high precision.

The inorganic hard mask is preferably formed by a CVD method or an ALD method.

According to such a patterning process, the inorganic hard mask can be formed.

The circuit pattern is preferably formed by a lithography using light having a wavelength of 10 nm or more and 300 nm or less, a direct writing with electron beam, nanoimprinting, or a combination thereof.

The circuit pattern is preferably developed with an alkaline development or an organic solvent.

Such a patterning process can be used suitably as means of forming and developing a circuit pattern.

In the above-described patterning processes, the body to be processed is preferably a semiconductor device substrate or the semiconductor device substrate coated with any of a metal film, a metal carbide film, a metal oxide film, a metal nitride film, a metal oxycarbide film, and a metal oxynitride film.

In the above-described patterning processes, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning processes, such a body to be processed can be processed to form a pattern.

The present invention provides a polymer for a composition for forming an organic film, the polymer not containing a halogen atom and containing a repeating unit represented by the following formula (1) and a repeating unit represented by the following formula (1'), 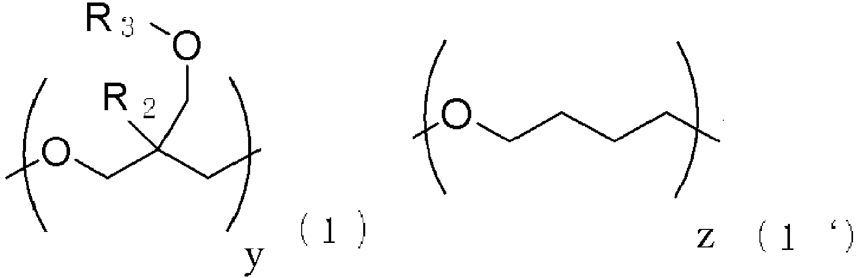 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.

Such a polymer for a composition for forming an organic film can be applied suitably to a composition for forming an organic film that makes it possible to form an organic film having excellent in-plane uniformity and excellent filling property and in which the formation of humps due to the effect of a remover in an EBR process has been suppressed. Furthermore, such a polymer for a composition for forming an organic film gives a polymer for a composition for forming an organic film that can achieve a suitable contact angle of the organic film surface and is excellent in the coating property of a silicon-containing middle layer film.

The polymer is preferably represented by the following formula (2), 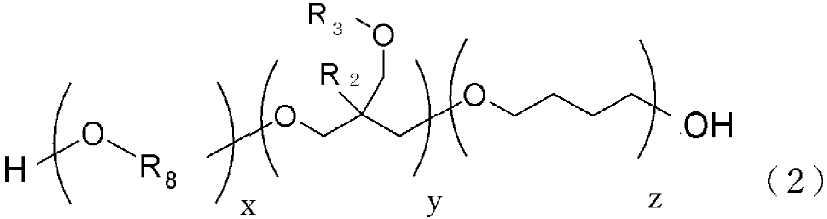 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.

Such a polymer for a composition for forming an organic film can be provided with enhanced uniformity, and when the polymer is contained in a composition for forming an organic film, it is possible to form an organic film having excellent in-plane uniformity and excellent filling property and in which the formation of humps due to the effect of a remover in an EBR process has been suppressed.

The polymer is preferably represented by the following formula (3), 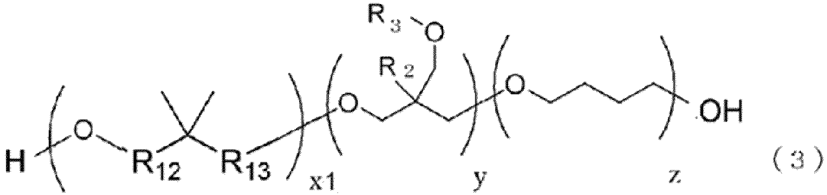 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.

Such a polymer for a composition for forming an organic film can provide a composition for forming an organic film that has improved film-formability at the time of application, carries no risk of degradation in the in-plane uniformity of the film due to decomposition products generated during baking, and in which no insoluble matter is formed due to reaction between decomposition products or the like.

The "x", "y", and "z" in the general formula (2) preferably satisfy x+y+z = 1, z < x < y, and z+x < y.

In this range, the polymer can be applied more suitably to a composition for forming an organic film used as a processing material for a semiconductor.

The polymer preferably has a weight-average molecular weight of 1000 to 30000.

When the weight-average molecular weight is in such a range, it is possible to form an organic film excellent in film-formability and filling property.

### ADVANTAGEOUS EFFECTS OF INVENTION

As described above, the present invention can provide a composition for forming an organic film that is excellent in film-formability (in-plane uniformity) on a substrate (wafer) and filling property, excellent in film-formability on an organic film when used for an organic film, and can suppress humps at the time of an EBR process. The inventive composition for forming an organic film is excellent in film-formability, filling property, and suppression of humps generated at the time of an EBR process, and therefore is extremely useful as: an organic film material used in multilayer resist processes, such as a two-layer resist process, a three-layer resist process using a silicon-containing resist middle layer film or an inorganic hard mask, or a four-layer resist process using a silicon-containing resist middle layer film or inorganic hard mask and an organic antireflective film or an adhesive film; an organic film formation material for manufacturing a semiconductor device; etc. Furthermore, according to the inventive method for forming an organic film, an organic film in which humps have been suppressed can be formed, and therefore, a semiconductor device or the like can be manufactured efficiently.

### BRIEF DESCRIPTION OF DRAWINGS

FIG. 1 is an example of a graph on measuring the height of a hump by using a stylus profiler in the case of a composition for forming an organic film in which humps have been suppressed.
FIG. 2 is an example of a graph on measuring the height of a hump by using a stylus profiler in the case of a composition for forming an organic film in which humps have not been suppressed.
FIG. 3 is an explanatory diagram of an example of the inventive patterning process according to a three-layer resist process.
FIG. 4 is an explanatory diagram of a filling property evaluation method in the Examples.

### DESCRIPTION OF EMBODIMENTS

As described above, there have been demands for the development of a composition for forming an organic film that is excellent in film-formability (in-plane uniformity) on a substrate (wafer) and filling property and in which humps at the time of an EBR process have been suppressed.

Normally, when an organic film is to be formed, a resin for forming an organic film, an additive, etc. are dissolved in an organic solvent to form a composition, the composition is applied with a coater and a developer onto a substrate on which a structure, a circuit, etc. is formed, the composition is spread by the substrate rotating, the composition on the edge is removed in an EBR process, and then the composition is baked to form an organic film.

It can be assumed that if the flowability of the composition is insufficient, gaps occur when a hole or trench having a very high aspect ratio is filled, and in addition, humps occur in peripheral portions of the organic film if the resin for forming an organic film or additives have poor solubility in the remover used in the EBR process.

The present inventors have further studied earnestly and found out that when a thermally decomposable compound having a particular repeating unit is contained in a composition for forming an organic film, the composition gives a composition for forming an organic film excellent in film-formability, high filling property, and hump suppression at the time of an EBR process. Thus, the present invention has been completed.

That is, the present invention is a composition for forming an organic film, comprising: a resin and/or compound (A) for forming an organic film; a polymer (B) not containing a halogen atom and containing a repeating unit represented by the following formula (1) and a repeating unit represented by the following formula (1'); and a solvent (C), 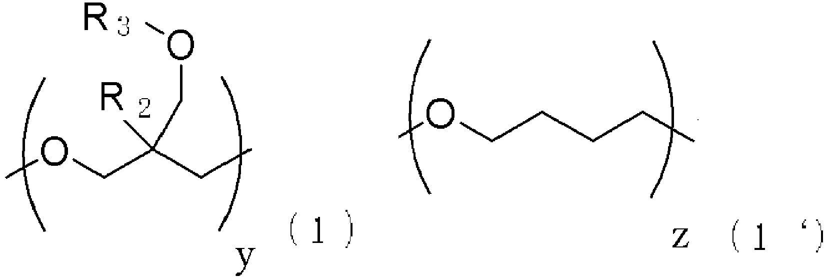 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.

Hereinafter, the present invention will be described in detail, but the present invention is not limited thereto.

### [Composition for Forming Organic Film]

The inventive composition for forming an organic film contains components (A), (B), and (C). First, the component (B) will be described, and then the component (A), the component (C), and other components will be described.

### [Component (B)]

The component (B) is a polymer (B) not containing a halogen atom and containing a repeating unit represented by the formula (1) and a repeating unit represented by the formula (1').

The component (B) can be synthesized by ring-opening polymerization using a cationic polymerization catalyst, tetrahydrofuran, and an oxetane-ring-containing compound represented by the following formula (4).

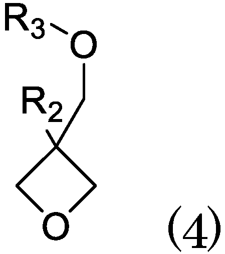

In the formula, R₂ and R₃ each independently represent a saturated or unsaturated organic group having 1 to 20 carbon atoms and optionally having a substituent.

The component (B) of the present invention functions as a surfactant that imparts excellent film-formability and high leveling property. Furthermore, the component (B) is applicable not only to materials for forming an organic film but also to silicon-containing resist middle layer films, and is usable as a surfactant suitable for achieving highly versatile film-formability applicable to various film formation materials.

The component (B) of the present invention functions as a surfactant that brings about a uniform coating property (leveling property) of the organic film by R₂ and R₃ being organic groups. Therefore, when the compound of the present invention is used as a surfactant, the compound can be used not only for organic films but also for coating materials for photolithography in general. Specific examples include photosensitive resist materials and materials for forming a top coat to be formed on a resist film. Furthermore, a compound in which R₃ is a branched alkyl exhibits the advantageous effects more suitably as a surfactant that provides a suitable contact angle.

The repeating unit of the formula (1) is derived from an oxetane compound of the formula (4), being a synthesis raw material. The R₂ and R₃ are the R₂ and R₃ of the oxetane compound.

In the formula (1), R₂ represents a saturated or unsaturated organic group having 1 to 20 carbon atoms and optionally having a substituent. As the organic group, a substituted or unsubstituted alkyl group having 1 to 20 carbon atoms is preferable. Specific examples thereof include a methyl group, an ethyl group, an n-propyl group, an i-propyl group, an n-butyl group, an i-butyl group, a sec-butyl group, a t-butyl group, an n-pentyl group, and an n-hexyl group. From the viewpoint of the availability of raw materials, a methyl group or an ethyl group is preferable.

As the organic group represented by R₃, preferable are substituted or unsubstituted alkyl groups having 1 to 20 carbon atoms and substituted or unsubstituted alkoxycarbonyl groups having 2 to 20 carbon atoms.

Specific examples thereof include: alkyl groups, such as a methyl group, an ethyl group, an n-propyl group, an i-propyl group, an n-butyl group, an i-butyl group, a sec-butyl group, a t-butyl group, an n-pentyl group, and an n-hexyl group; and alkoxycarbonyl groups, such as a methoxycarbonyl group, an ethoxycarbonyl group, a n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group. Branched alkyl groups are preferable, and examples include branched alkyl groups having 3 to 20 carbon atoms, such as an i-propyl group, an i-butyl group, a sec-butyl group, and a tert-butyl group.

The formula (1') is a repeating unit derived from tetrahydrofuran, being a raw material.

The component (B) polymer is preferably represented by the following formula (2).

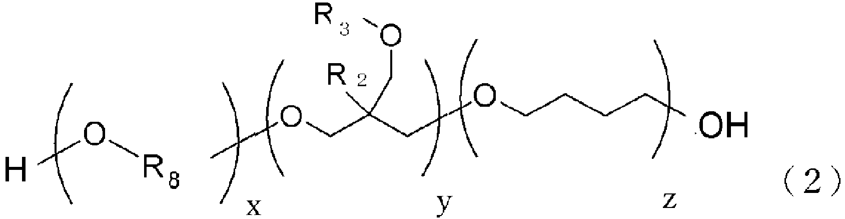

In the formula, R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.

The polymer represented by the formula (2) can be synthesized by ring-opening polymerization using a cationic polymerization catalyst, tetrahydrofuran, an oxetane-ring-containing compound represented by the formula (4), and a diol represented by the following formula (5).

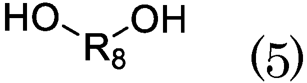

In the formula, R₈ represents a saturated or unsaturated organic group having 1 to 20 carbon atoms and optionally having a substituent.

The compound represented by the formula (5) is a diol compound to be used as a raw material when the polymer of the formula (2) is synthesized. The R₈ in the formula (2) is the R₈ of the compound represented by the formula (5) to be used as a raw material.

R₈ may be a divalent saturated chain hydrocarbon group, such as a methylene group, an ethylene group, an n-propylene group, an i-propylene group, an n-butylene group, an i-butylene group, a sec-butylene group, a tert-butylene group, an n-pentylene group, an iso-pentylene group, a sec-pentylene group, and a tert-pentylene group; a divalent unsaturated chain hydrocarbon group, such as an ethenylene group, a propenylene group, a butenylene group, a pentenylene group, an ethynylene group, and a propynylene group; a divalent monocyclic saturated cyclic hydrocarbon group, such as a cyclobutylene group, a cyclopentylene group, a cyclohexylene group, a cycloheptylene group, and a cyclooctylene group; a monocyclic unsaturated cyclic hydrocarbon group, such as a cyclobutenylene group, a cyclopentenylene group, and a cyclohexenylene group; a divalent polycyclic cyclic hydrocarbon group, such as a norbornylene group and an adamantylene group; or a divalent aromatic hydrocarbon group, such as a phenylene group, a methylphenylene group, a naphthylene group, a methylnaphthylene group, an anthrylene group, and a methylanthrylene group.

These substituents may further be substituted with a substituent. R₈ is preferably an unsubstituted alkylene group or an alkylene group substituted with an alkyl group.

A composition for forming an organic film containing such a compound can be provided with improved film-formability at the time of application without fluorine being contained. Moreover, there is no risk of the in-plane uniformity of the film being degraded by a decomposition product generated during baking, and there is no risk of insoluble matter being formed by a reaction between decomposition products or the like. Therefore, there are no risks of process margin being narrowed when the composition is used for an organic film, or of apparatus contamination, inconvenience, etc. occurring.

In the polymer represented by the formula (2), the "x", "y", and "z" in the formula preferably each independently satisfy 0 < x < 1, 0 < y < 1, and 0 < z < 1, provided that x+y+z = 1.

It is preferable that the "x", "y", and "z" in the formula (2) satisfy x+y+z = 1, z < x < y, and z+x < y.

A polymer having such a structure can provide a composition for forming an organic film having an appropriate contact angle.

Furthermore, the component (B) polymer is preferably represented by the following formula (3).

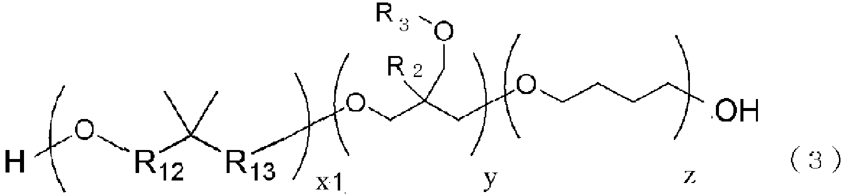

In the formula, R₂ and R₃ are as defined in the formula (2); R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.

In the formula (3), the unit repeated "x1" times is derived from the diol compound represented by the formula (5), being a raw material. The unit repeated "y" times is derived from the oxetane compound represented by the formula (4), being another raw material. The unit repeated "z" times is derived from tetrahydrofuran, being another raw material.

As the divalent organic groups represented by R₁₂ and R₁₃, preferable are divalent saturated hydrocarbon groups having 1 to 16 carbon atoms, divalent unsaturated chain hydrocarbon groups having 2 to 16 carbon atoms, divalent monocyclic saturated cyclic hydrocarbon groups having 6 to 16 carbon atoms, divalent monocyclic unsaturated cyclic hydrocarbon groups having 6 to 16 carbon atoms, divalent polycyclic cyclic hydrocarbon groups having 6 to 16 carbon atoms, and divalent aromatic hydrocarbon groups having 6 to 16 carbon atoms. Specific examples of R₁₂ and R₁₃ include those given as examples of R₈. R₁₂ and R₁₃ are preferably each independently an unsubstituted alkylene group or an alkylene group substituted with an alkyl group.

When the groups are substituted, examples of substituents include alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; and alkoxycarbonyl groups such as a methoxycarbonyl group, an ethoxycarbonyl group, a n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group.

When the polymer has the structure represented by the formula (3), the molecular weight can be adjusted easily from the viewpoint of polymer synthesis, and a uniform polymer can be obtained.

Specific examples of the oxetane compound represented by the formula (4), being a synthesis raw material of the polymer of the formula (2), include the following, but are not limited thereto.

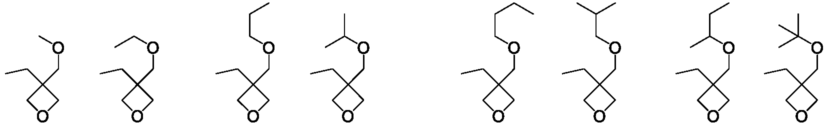

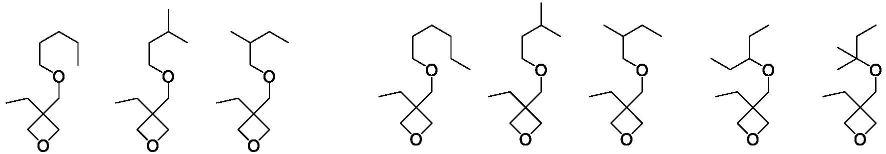

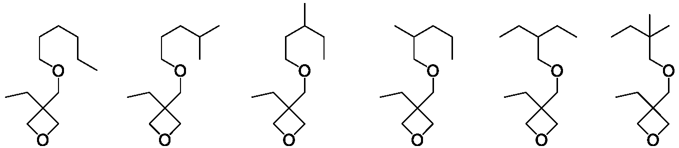

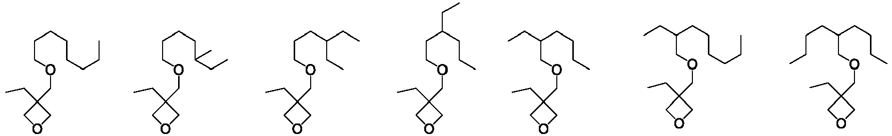

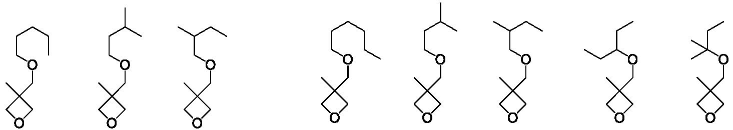

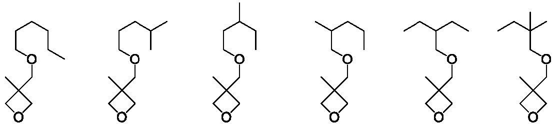

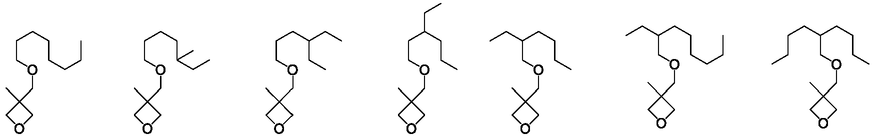

Specific examples of the structure derived from a diol in the polymer represented by the formula (2) include the following, but are not limited thereto.

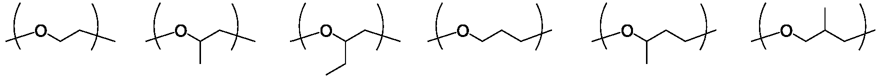

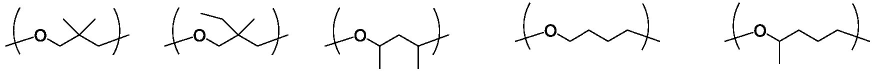

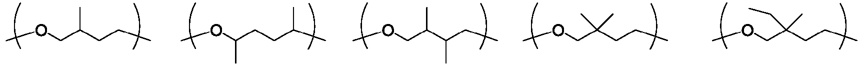

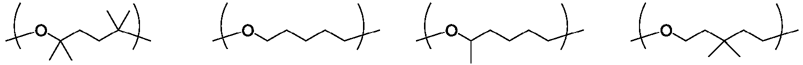

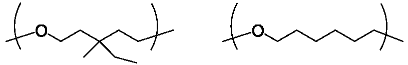

As the compound of the formula (5), which is to be a synthesis raw material of the polymer of the formula (2), the following are preferable.

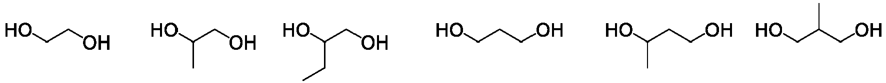

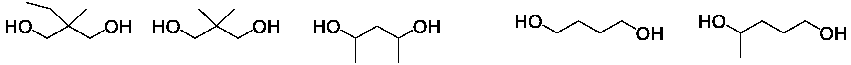

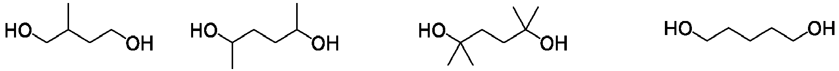

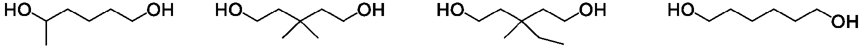

Such structures make it possible to adjust thermal decomposition property, surface active effect, and flowability of the polymer, and a compound having all of film-formability, filling property, etc. can be achieved.

The polymer (B) preferably has a weight-average molecular weight of 1000 to 30000.

Such a polymer can suppress the degradation of the blending effect due to volatilization or the like, and a composition for forming an organic film that can achieve a sufficient blending effect can be provided. The polymer (B) more preferably has a weight-average molecular weight of 1,500 to 25,000. When the weight-average molecular weight is 1,000 or more, there are no problems originating from volatility, and when the weight-average molecular weight is 30,000 or less, there is no degradation etc. of flowability, and excellent filling property can be achieved.

Note that, in the present invention, weight-average molecular weight (Mw) and number-average molecular weight (Mn) are values on polystyrene basis measured by gel permeation chromatography (GPC) using tetrahydrofuran as an eluent (solvent), and dispersity (Mw/Mn) is calculated from Mw and Mn.

### [Method for Synthesizing Polymer (B)]

In the following, methods for synthesizing the inventive polymer (B) will be described.

As a means of obtaining the compound of the present invention for forming an organic film, the compound is synthesized by the cationic polymerization of an oxetane compound in the presence of both a cationic polymerization catalyst (Lewis acid catalyst) and tetrahydrofuran. As the cationic polymerization catalyst, it is possible to select appropriately and use one that has a function of initiating cationic polymerization. As the cationic polymerization catalyst, a Lewis acid catalyst is preferable. Specific examples of Lewis acid catalysts include metal halides (BF₃, AlCl₃, TiCl₄, SnCl₄, FeCl₃) and organometallic compounds (EtAlCl₂, Et₂AlCl, Et₃Al). Boron trifluoride (BF₃) is preferable.

The tetrahydrofuran can be present in the reaction system. As such a method, a boron trifluoride tetrahydrofuran complex can be used as the Lewis acid catalyst. In view of industrial availability, a boron trifluoride tetrahydrofuran complex or the like is preferably used.

In the ring-opening polymerization reaction of the oxetane, the dihydric alcohol represented by the formula (5) may also be present. In this case, a repeating unit derived from alcohol is contained in the polymer. One kind of each of the dihydric alcohol and the oxetane used for the synthesis may be used, or two or more kinds thereof may be used. These can be appropriately selected and combined in accordance with required properties.

This reaction is represented by the following reaction formula.

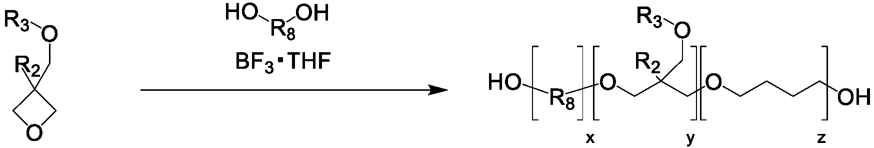

The R₂, R₃, and R₈ in the formula are as defined in the formula (2). "x", "y", and "z" each independently satisfy 0 ≤ x < 1, 0 < y < 1, and 0 < z < 1, provided that x+y+z = 1.

The amount of the Lewis acid catalyst to be used in this event is preferably 0.01 to 1 mol, more preferably 0.02 to 0.2 mol based on 1 mol of the raw material oxetane.

The solvent used in this event is not particularly limited as long as the solvent is inactive in the above-described reaction. Examples of the solvent include: halogen-based solvents, such as 1,2-dichloromethane and chloroform; aromatic solvents, such as benzene, toluene, and xylene; and acetonitrile, dimethyl sulfoxide, N,N-dimethylformamide, and N-methylpyrrolidone. One of these may be used, or a mixture of two or more thereof may be used. These solvents can be used in a range of 0 to 2000 parts by mass based on 100 parts by mass of the raw materials for the reaction, and the reaction temperature is preferably about -50°C to the boiling point of the solvent, further preferably room temperature to 150°C. The reaction time is appropriately selected from 0.1 to 100 hours.

Examples of reaction methods include: a method in which boron trifluoride tetrahydrofuran and a dihydric alcohol or an oxetane are charged into a solvent at once; a method in which each of or a mixture of boron trifluoride tetrahydrofuran and a dihydric alcohol or an oxetane is dispersed or dissolved and then charged by adding dropwise; and a method in which boron trifluoride tetrahydrofuran and one of the dihydric alcohol or the oxetane is dispersed or dissolved in a solvent, and then the other, dispersed or dissolved in a solvent, is charged by adding dropwise. In addition, in a case where multiple kinds of each of the dihydric alcohol or the oxetane are charged, the materials may be mixed and reacted beforehand, or may be reacted individually in succession.

The reaction solution obtained by the manufacturing method of the present invention may be diluted in an organic solvent and then subjected to liquid-liquid separation washing to remove unreacted raw materials, the catalyst, etc. present in the system, and the product can be collected.

The organic solvent used in the liquid-liquid separation washing is not particularly limited, as long as it is capable of dissolving the compound and being separated, when mixed with water, into two layers. Specific examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; etc. As water used for washing in this event, generally, what is called deionized water or ultrapure water may be used. The washing may be performed at least once, preferably once to approximately five times, because washing ten times or more does not always produce the full washing effects thereof.

In the liquid-liquid separation washing, washing with a basic aqueous solution may be performed to remove unreacted raw materials or acidic components in the system. Specific examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, washing with an acidic aqueous solution may be performed to remove unreacted raw materials, metal impurities, or basic components in the system. Specific examples of the acid include inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing metal impurities.

After the liquid-liquid separation washing with the basic aqueous solution and acidic aqueous solution, washing with neutral water may be successively performed. As the neutral water, deionized water, ultrapure water, or the like mentioned above may be used. The washing is preferably performed once or more times and ten or fewer times, further preferably once to approximately five times. When washing is performed basic components and acidic components can be removed, and washing 10 or fewer times is economically advantageous.

Further, after the liquid-liquid separation operation, the reaction product can also be collected as a powder by concentrating and drying the solvent or crystallizing the reaction product under reduced pressure or normal pressure. Alternatively, the reaction product can be retained in a solution state with an appropriate concentration to improve the workability in preparing the composition for forming an organic film. The concentration in this case is preferably 0.1 to 50 mass%, more preferably 0.5 to 30 mass%. When the concentration is as described, the viscosity is hardly high, so that the workability can be prevented from being impaired, and the amount of the solvent is not excessive, so that the solution can be prepared economically.

The solvent used in this event is not particularly limited, as long as it is capable of dissolving the compound. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl **3-**ethoxypropionate, tert-butyl acetate, tert-butyl propionate, and propylene glycol mono-tert-butyl ether acetate. One of these solvents or a mixture of two or more thereof can be used.

This polymer is useful for forming an organic film. The polymer may have two kinds of the structure represented by the formula (2).

The inventive composition for forming an organic film can contain one kind of each of the polymer (B), the resin or compound (A) for forming an organic film, and the solvent (C), or a combination of two or more kinds of each.

### [Resin and/or Compound (A) for Forming Organic Film]

The resin and/or compound (A) for forming an organic film contained in the composition for forming an organic film will be described.

The resin and/or compound (A) for forming an organic film contained in the inventive composition for forming an organic film is not particularly limited as long as the material is a resin or compound that has sufficient film-formability in spin-coating and curability. When the composition is used as an organic underlayer film material, a resin or compound including an aromatic skeleton is preferable from the viewpoints of etching resistance, optical characteristics, heat resistance, etc.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. Among these, benzene, naphthalene, fluorene, and carbazole are particularly preferable.

In the following, the material (A) for forming an organic film will be described with reference to specific examples, but these are simply examples, and the material is not limited thereto. In addition, the numbers of the formulae shown in the following examples apply only for the description of the following formulae.

Examples of the material (resin or compound) (A) for forming an organic film used in the present invention include resins containing the following structures, disclosed in JP 2012-001687 A and JP 2012-077295 A.

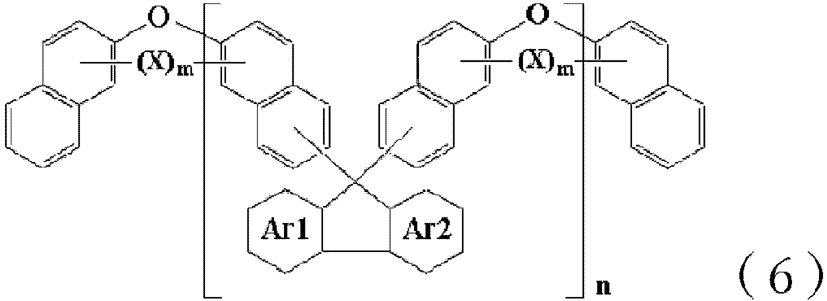

In the formula (6), the cyclic structures Ar1 and Ar2 each represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the symbols in the formula apply only in this formula. 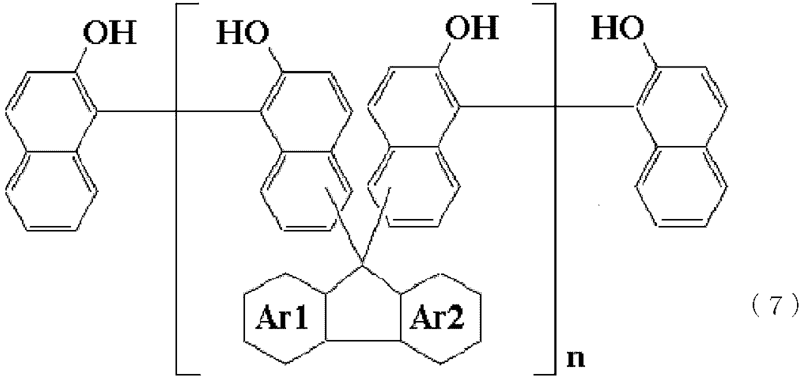 In the formula (7), the cyclic structures Ar1 and Ar2 each represent a benzene ring or a naphthalene ring. "n" represents any natural number that provides a weight-average molecular weight of 100,000 or less as measured by gel permeation chromatography in terms of polystyrene. Note that the symbols in the formula apply only in this formula.

Further examples of the material (A) for forming an organic film used in the present invention include resins containing the following structures, disclosed in JP 2004-264710 A, JP 2005-043471 A, JP 2005-250434 A, JP 2007-293294 A, and JP 2008-065303 A.

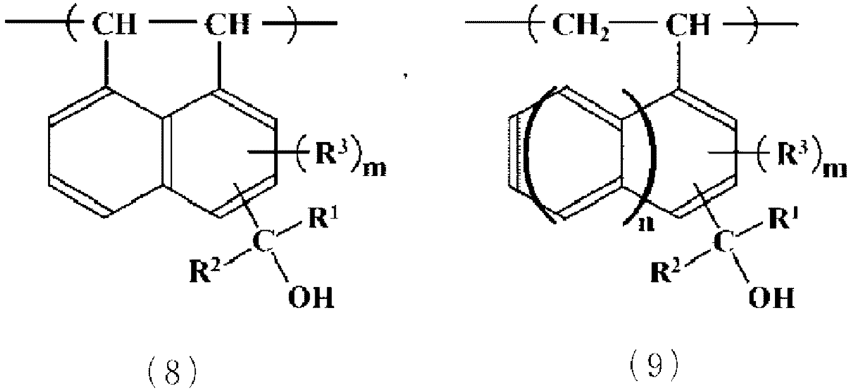

In the formula (8) and the formula (9), R¹ and R² each represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the symbols in the formulae apply only in these formulae. 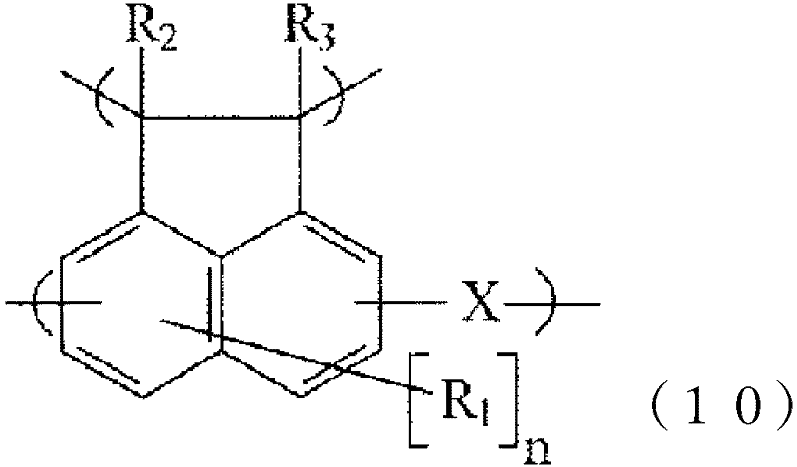 In the formula (10), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the symbols in the formula apply only in this formula. 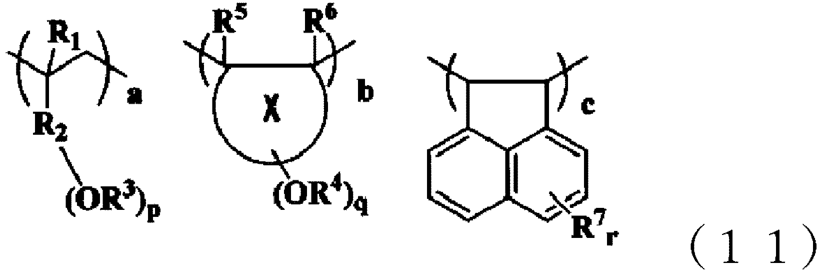 In the formula (11), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of any of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the symbols in the formula apply only in this formula. 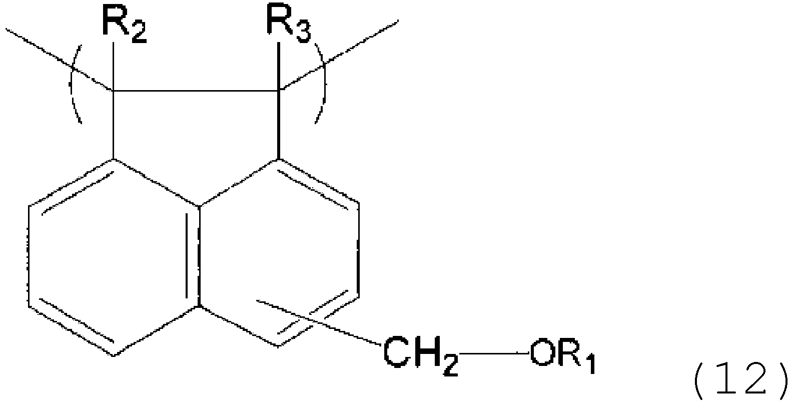 In the formula (12), R₁ represents a hydrogen atom or a monovalent organic group; and R₂ and R₃ each independently represent a monovalent atom or a monovalent organic group. Note that the symbols in the formula apply only in this formula.

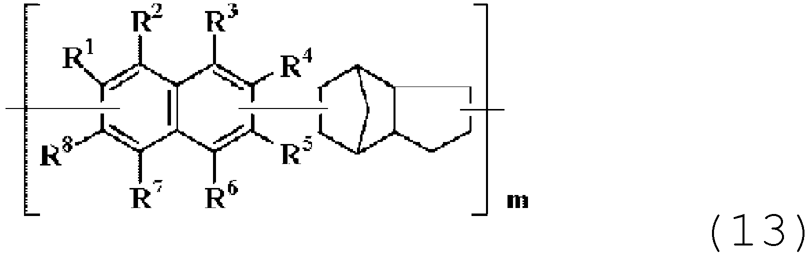

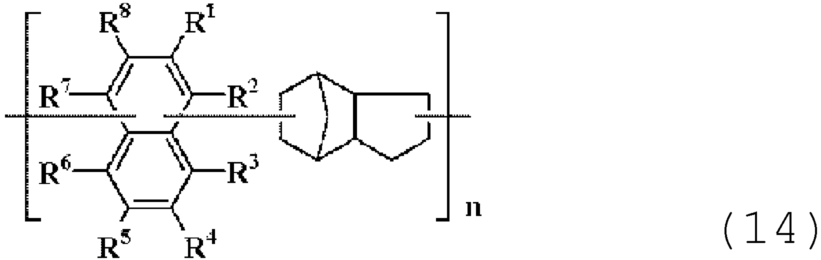

Specific examples of the material (A) for forming an organic film used in the present invention include resins containing the following structures, disclosed in JP 2004-205685 A, JP 2007-171895 A, and JP 2009-014816 A.

In the formula (13) and the formula (14), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the symbols in the formulae apply only in these formulae.

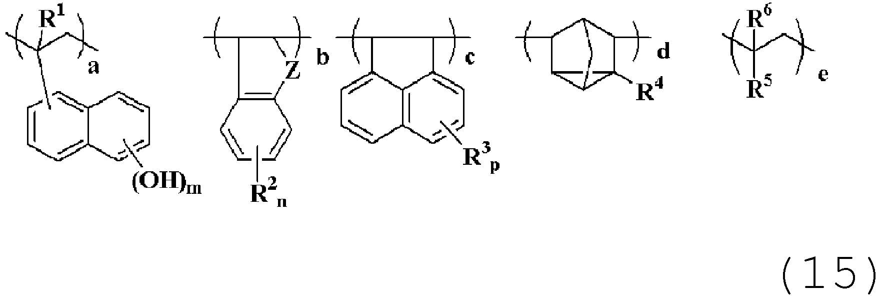

In the formula (15), R¹ and R⁶ each represent a hydrogen atom or a methyl group. R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the symbols in the formula apply only in this formula. 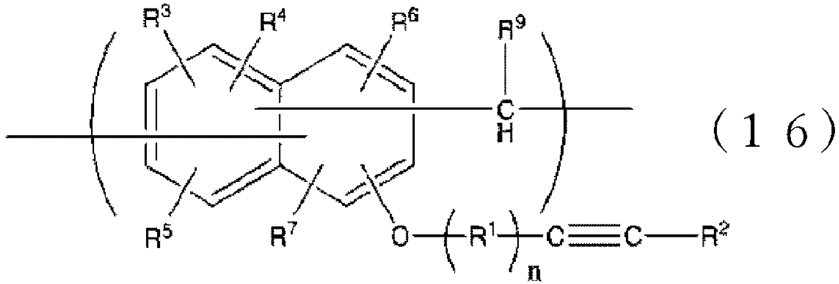 In the formula (16), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the symbols in the formula apply only in this formula.

Examples of the formula (16) include the following resins.

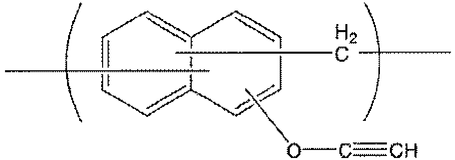

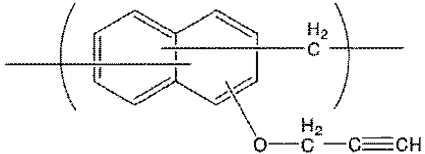

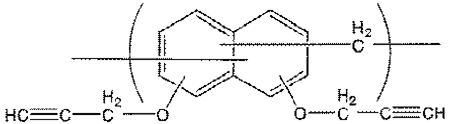

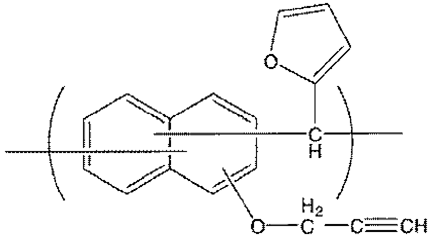

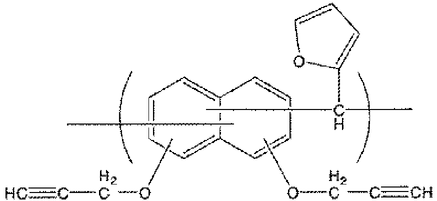

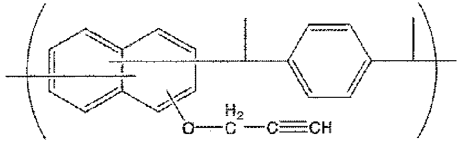

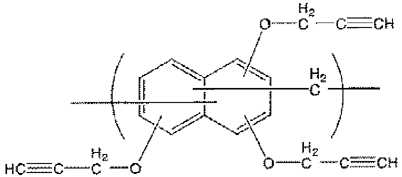

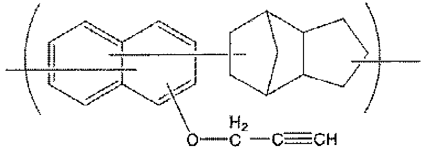

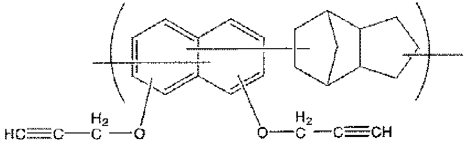

Further examples of the material (A) for forming an organic film used in the present invention include resins containing the following structures, disclosed in JP 2007-199653 A, JP 2008-274250 A, and JP 2010-122656 A.

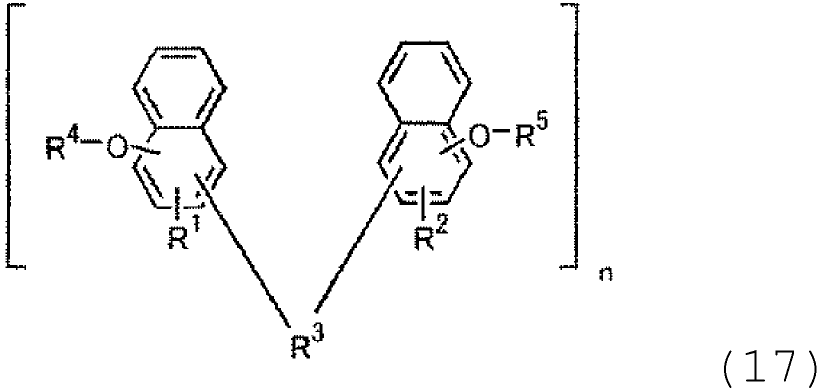

In the formula (17), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the symbols in the formula apply only in this formula.

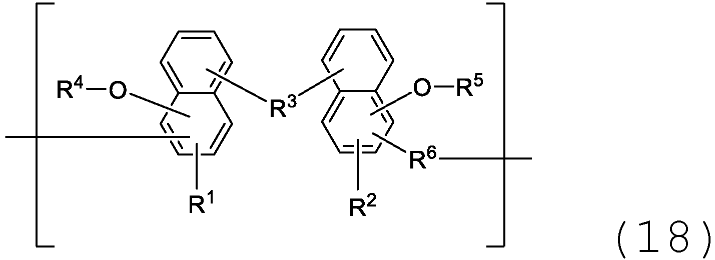

In the formula (18), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the symbols in the formula apply only in this formula. 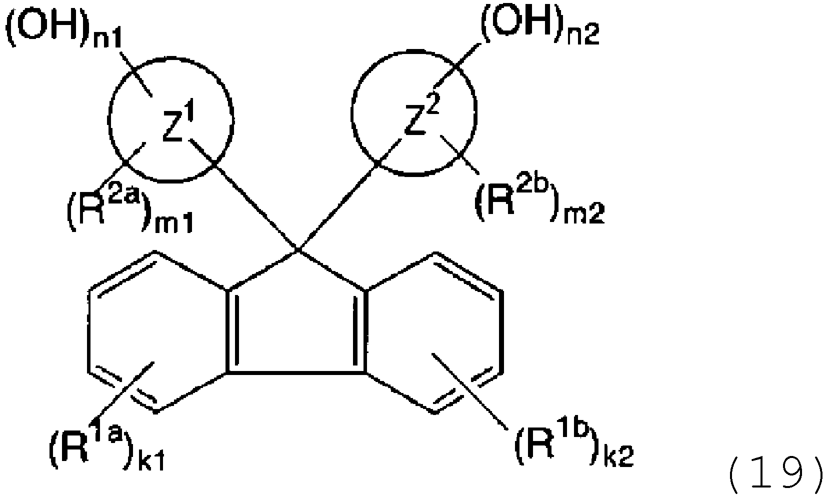 In the formula (19), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each represent 0 or an integer of 1 or more; and "n1" and "n2" each represent 0 or an integer of 1 or more. Here, n1+n2 ≥ 1. Note that the symbols in the formula apply only in this formula. 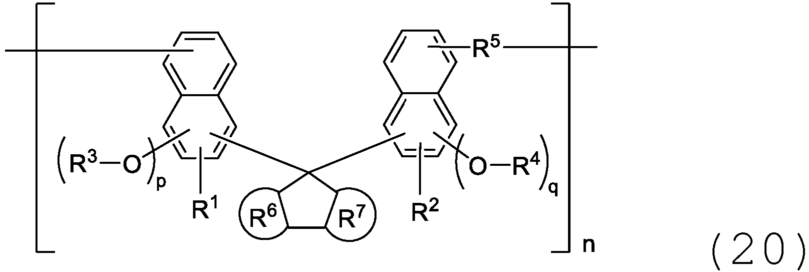 In the formula (20), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each represent a hydrogen atom or a glycidyl group; R⁵ represents a single bond or a linear or branched alkylene group having 1 to 10 carbon atoms; and R⁶ and R⁷ each represent a benzene ring or a naphthalene ring. "p" and "q" each represent 1 or 2. "n" satisfies 0 < n ≤ 1. Note that the symbols in the formula apply only in this formula.

Examples of the formula (20) include the following resins.

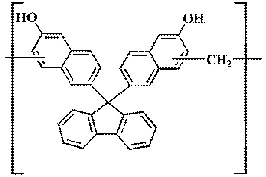

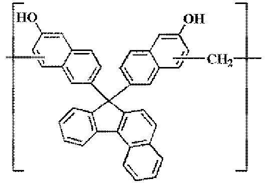

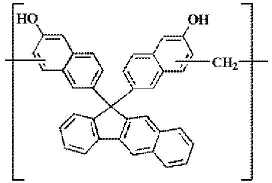

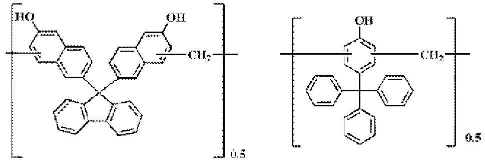

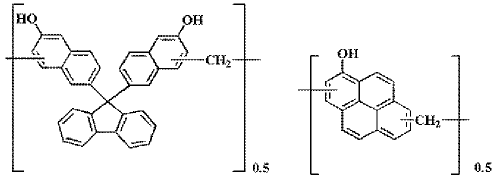

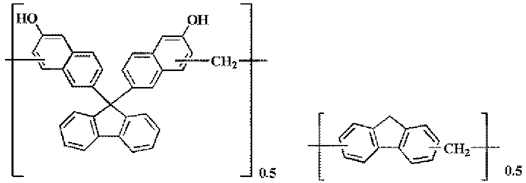

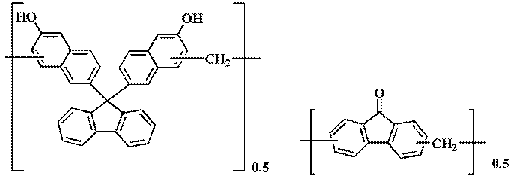

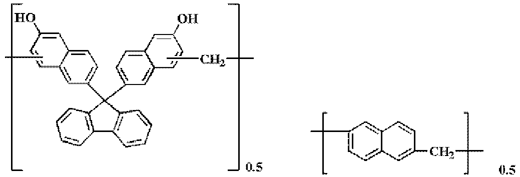

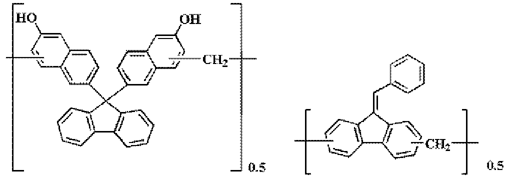

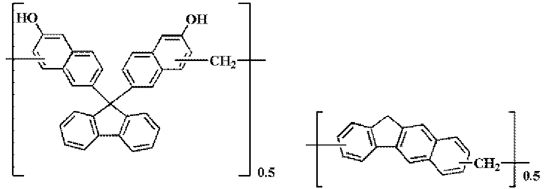

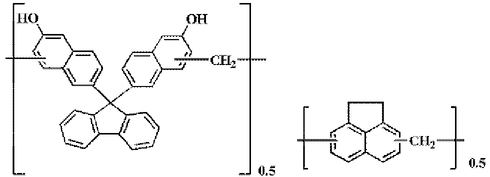

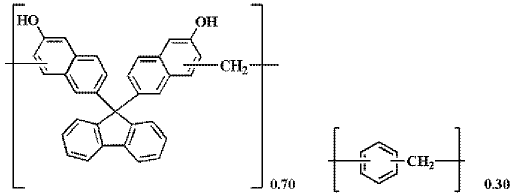

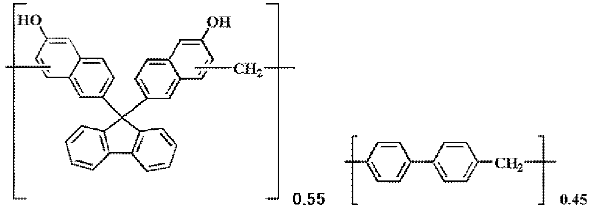

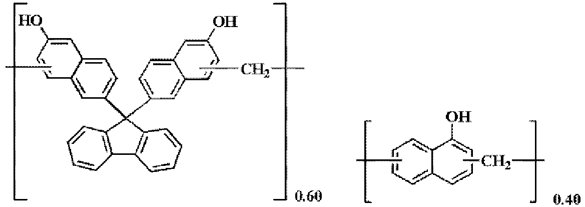

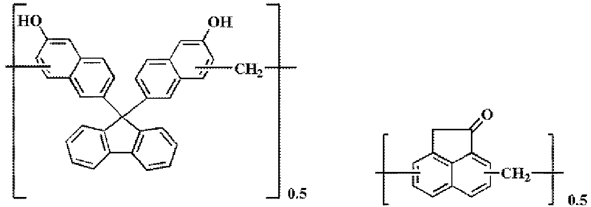

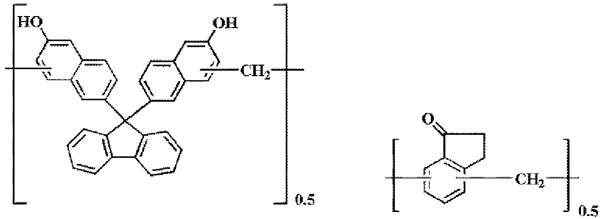

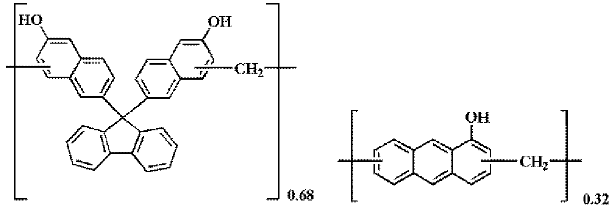

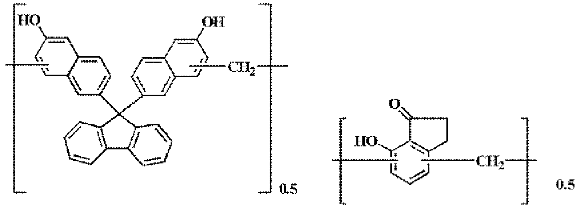

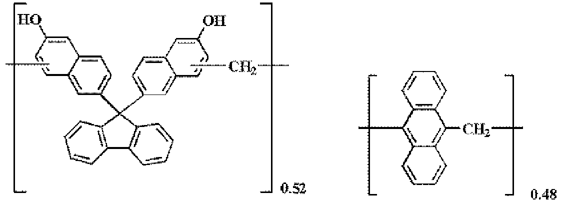

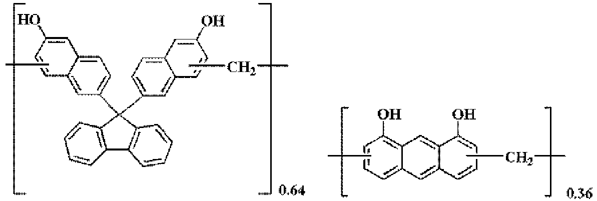

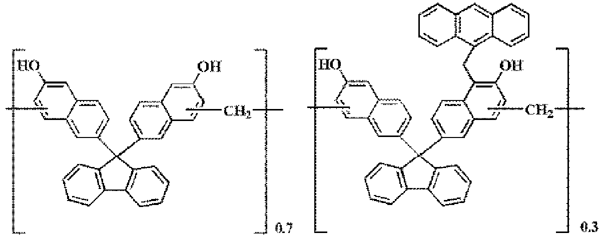

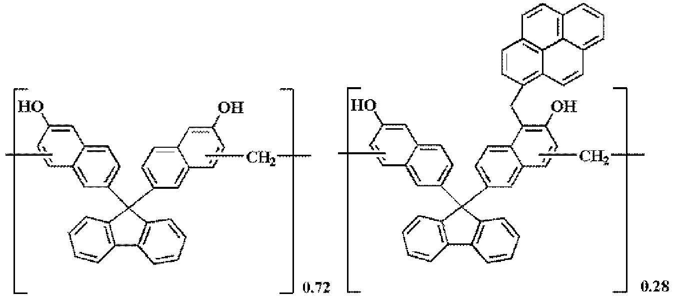

Examples of the material (A) for forming an organic film used in the present invention include resins containing the following structure, disclosed in JP 2012-214720 A.

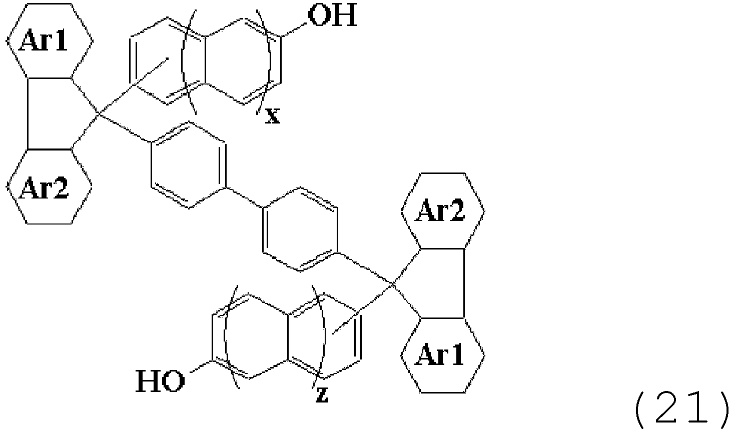

In the formula (21), the cyclic structures Ar1 and Ar2 each represent a benzene ring or a naphthalene ring. "x" and "z" each independently represent 0 or 1. Note that the symbols in the formula apply only in this formula.

Examples of the material (A) for forming an organic film used in the present invention include resins disclosed in JP 2014-029435 A.

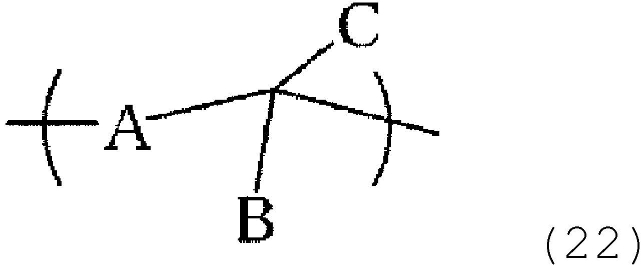

In the formula (22), A represents a structure having carbazole, B represents a structure having an aromatic ring, and C represents a hydrogen atom, an alkyl group, or a structure having an aromatic ring, B and C optionally constituting a ring with each other. One to four carboxy groups, a salt thereof, or a carboxylic acid ester group is contained in the combined structure of A, B, and C. Note that the symbols in the formula apply only in this formula.

Examples of the material (A) for forming an organic film used in the present invention include polymers disclosed in WO 2012/077640 A1, the polymers containing a unit structure represented by the following formula (23) and a unit structure represented by the following formula (24), where the ratio of the unit structure represented by the formula (23) to the unit structure represented by the formula (24) is 3 to 97 : 97 to 3 by molar ratio.

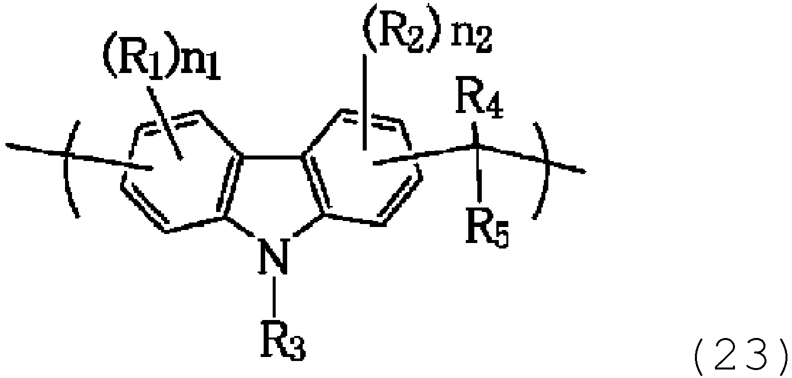

In the formula (23), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group having 6 to 40 carbon atoms and optionally being substituted with a halogen atom, a nitro group, an amino group, or a hydroxy group, or a heterocyclic group optionally being substituted with a halogen atom, a nitro group, an amino group, or a hydroxy group; R₅ represents a hydrogen atom, or an alkyl group having 1 to 10 carbon atoms and optionally being substituted with a halogen atom, a nitro group, an amino group or a hydroxy group, or an aryl group having 6 to 40 carbon atoms and optionally substituted with a halogen atom, a nitro group, an amino group or a hydroxy group, or a heterocyclic group optionally substituted with a halogen atom, a nitro group, an amino group or a hydroxy group; and R₄ and R₅ may form a ring with each other. "n1" and "n2" each represent an integer of 1 to 3. Note that the symbols in the formula apply only in this formula. 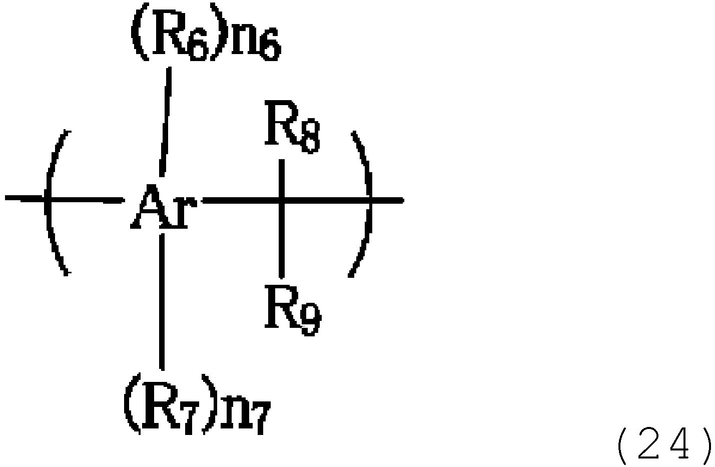 In the formula (24), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group having 6 to 40 carbon atoms and optionally being substituted with a halogen atom, a nitro group, an amino group, or a hydroxy group, or a heterocyclic group optionally substituted with a halogen atom, a nitro group, an amino group, or a hydroxy group; R₉ represents a hydrogen atom, or an alkyl group having 1 to 10 carbon atoms and optionally being substituted with a halogen atom, a nitro group, an amino group, or a hydroxy group, or an aryl group having 6 to 40 carbon atoms and optionally being substituted with a halogen atom, a nitro group, an amino group, or a hydroxy group, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the symbols in the formula apply only in this formula.

Examples of the material (A) for forming an organic film used in the present invention include polymers containing a unit structure represented by the following formula (25), disclosed in WO 2010/147155 A1.

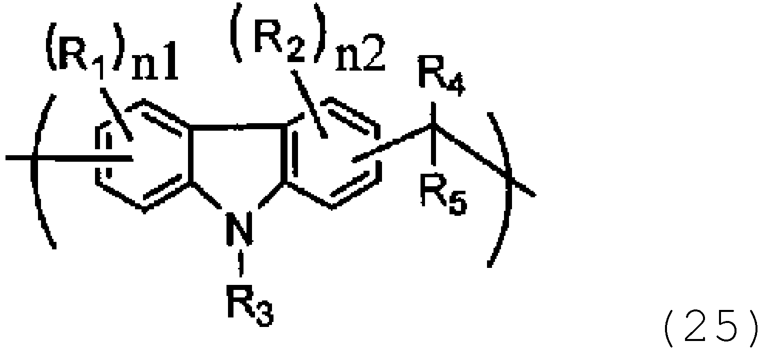

In the formula (25), R₁ and R₂ are each selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms, the aryl group or the heterocyclic group optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms, the alkyl group, the aryl group or the heterocyclic group optionally substituted with a halogen group, a nitro group, an amino group, or a hydroxy group; R₄ and R₅ optionally form a ring together with the carbon atom bonded to R₄ and R₅; and "n1" and "n2" each represent an integer of 1 to 3. Note that the symbols in the formula apply only in this formula.

Examples of the material (A) for forming an organic film used in the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (26), disclosed in WO 2012/176767 A1. 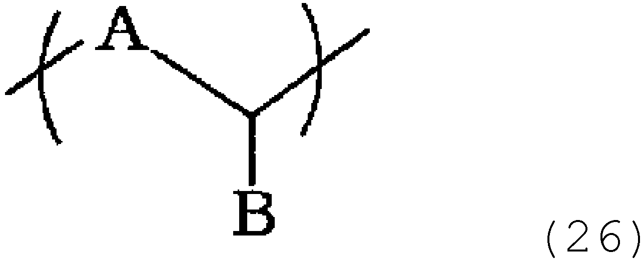 In the formula (26), A represents a hydroxy group-substituted phenylene group derived from polyhydroxybenzene; and B represents a monovalent condensed aromatic hydrocarbon ring group in which two to six benzene rings are condensed. Note that the symbols in the formula apply only in this formula.

Examples of the material (A) for forming an organic film used in the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (27-1) or (27-2).

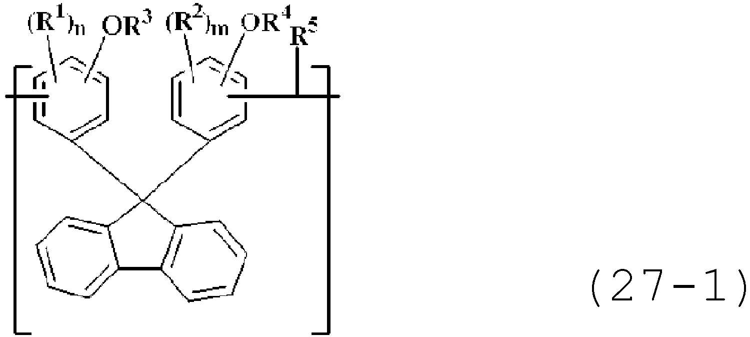

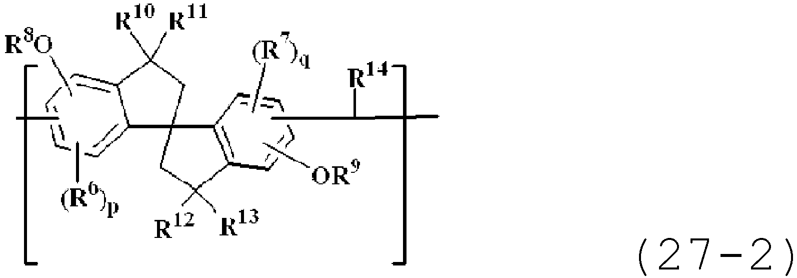

In the formula (27-1) and the formula (27-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the symbols in the formulae apply only in these formulae.

Examples of the material (A) for forming an organic film used in the present invention include reaction products obtained by a method disclosed in JP 2012-145897 A. More specific examples include polymers obtained by condensing one or more compounds represented by the following general formula (28-1) and/or (28-2) and one or more compounds represented by the following general formula (29-1) and/or (29-2) and/or an

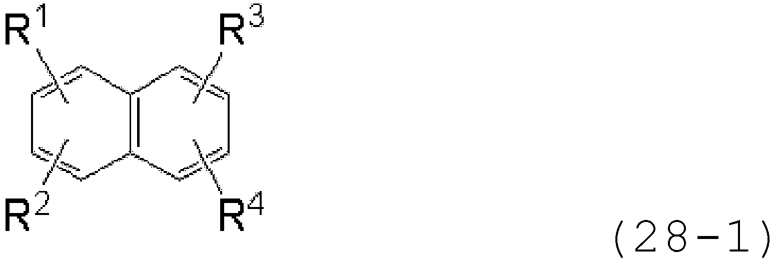

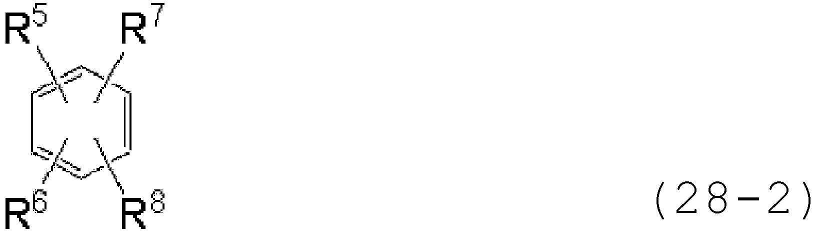

In the general formula (28-1) and the general formula (28-2), R¹ to R⁸ each independently represent a hydrogen atom, a halogen atom, a hydroxy group, an isocyanato group, a glycidyloxy group, a carboxy group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two of the above-described substituents selected from each of R¹ to R⁴ or R⁵ to R⁸ may be bonded to each other within a molecule to form a cyclic substituent. Note that the symbols in the formulae apply only in these formulae. 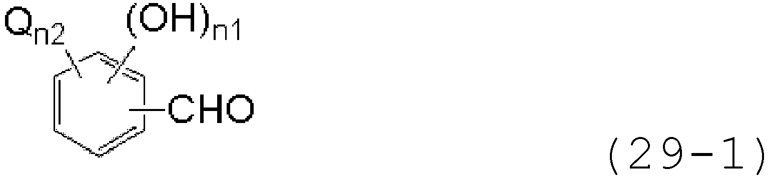 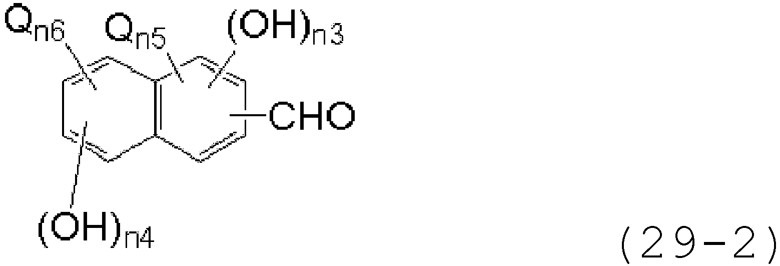 In the general formula (29-1) and the general formula (29-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (29-1), hydroxybenzaldehyde is excluded. Meanwhile, in the formula (29-2), the relationships 0 ≤ n3+n5 ≤ 3, 0 ≤ n4+n6 ≤ 4, and 1 ≤ n3+n4 ≤ 4 are satisfied. Note that the symbols in the formulae apply only in these formulae.

Further examples also include polymers obtained by condensing one or more compounds represented by the general formula (28-1) and/or (28-2), one or more compounds represented by the general formula (29-1) and/or (29-2) and/or an equivalent thereof, and one or more compounds represented by the following general formula (30) and/or an equivalent thereof.

Y-CHO (30)

In the formula (30), Y represents a hydrogen atom or a monovalent organic group having 30 or fewer carbon atoms and optionally having a substituent, and the formula (30) is different from the general formula (29-1) and the general formula (29-2). Note that the symbol in the formula applies only in this formula.

Examples of the material (A) for forming an organic film used in the present invention include compounds containing the following structure, disclosed in JP 2017-119671 A.

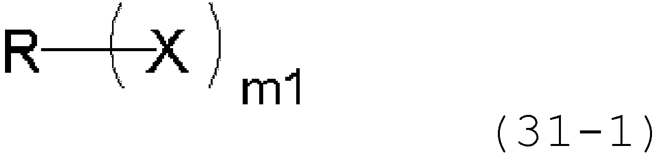

In the formula (31-1), R represents a single bond or an organic group having 1 to 50 carbon atoms; X represents a group represented by any of the following general formulae (31-2); and "m1" represents an integer that satisfies 2 ≤ m1 ≤ 10. Note that the symbols in the formula apply only in this formula.

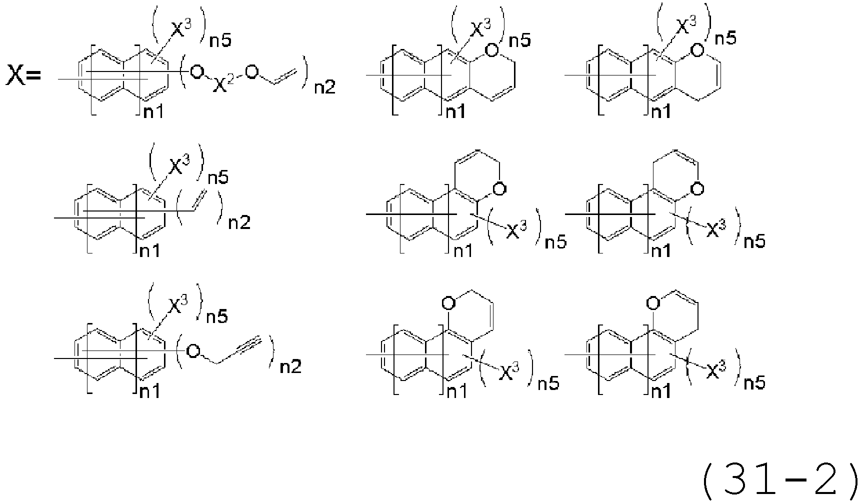

In the formulae, X² represents a divalent organic group having 1 to 10 carbon atoms; "n1" represents 0 or 1; "n2" represents 1 or 2; X³ represents a group represented by the following general formula (31-3); and "n5" represents 0, 1, or 2. Note that the symbols in the formulae apply only in these formulae.

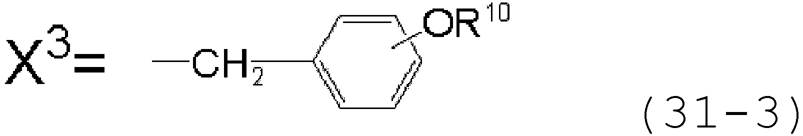

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the symbol in the formula applies only in this formula.

Examples of the compounds containing the above-described structures include the following compounds.

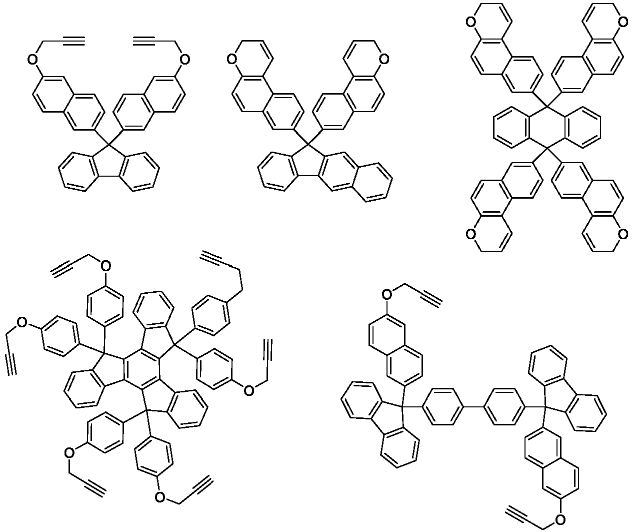

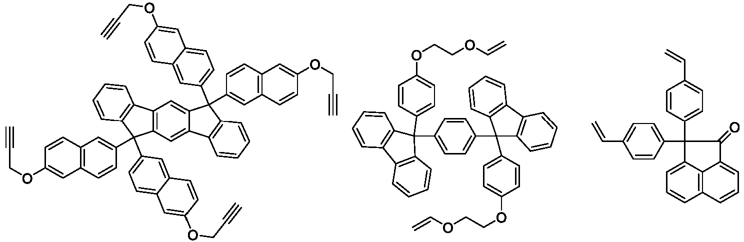

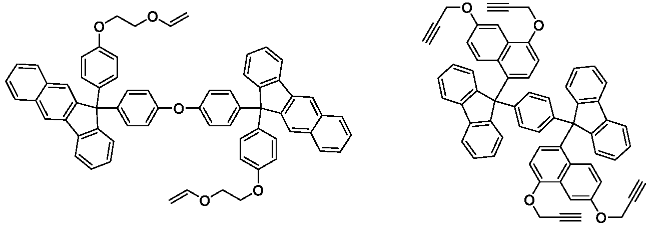

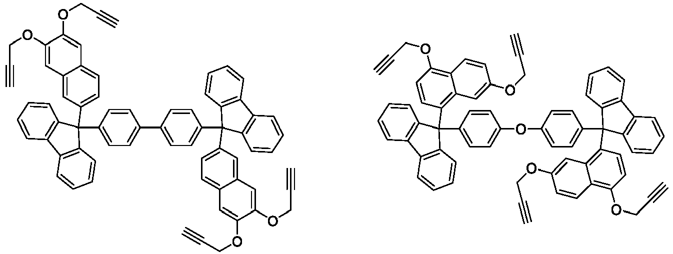

Examples of the material (A) for forming an organic film used in the present invention include polymers having a repeating unit represented by the following general formula (32-1), disclosed in JP 2019-044022 A.

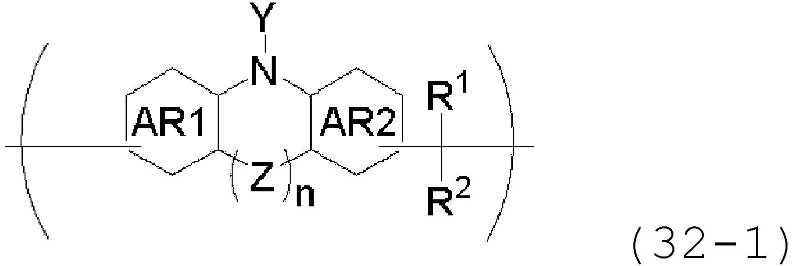

In the formula (32-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (32-2). Y represents a group represented by the following formula (32-3). Note that the symbols in the formula apply only in this formula.

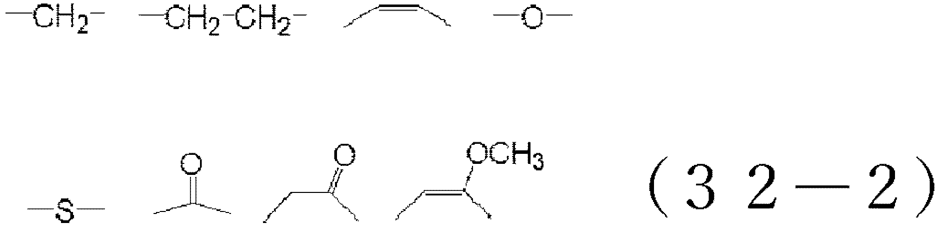

----R³-C≡C-R⁴ (32-3)

In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the symbols in the formula apply only in this formula.

Examples of the polymers having a repeating unit represented by the general formula (32-1) include the following polymers.

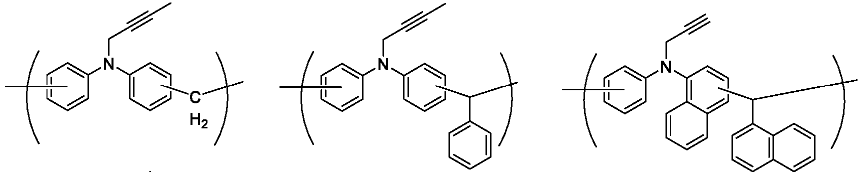

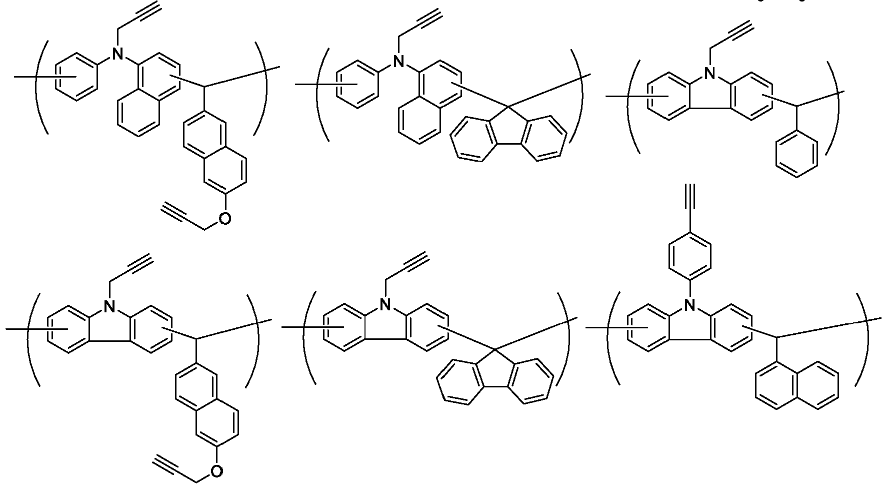

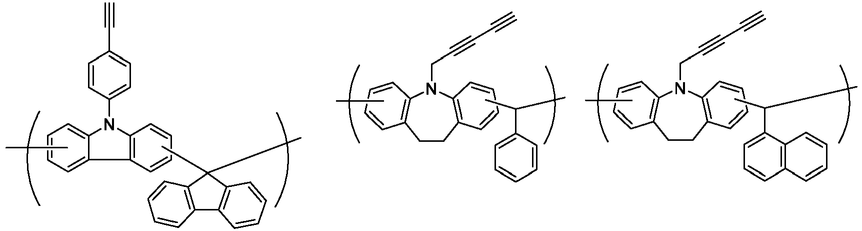

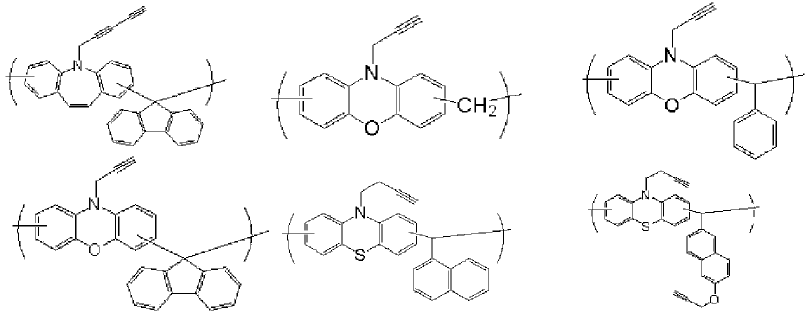

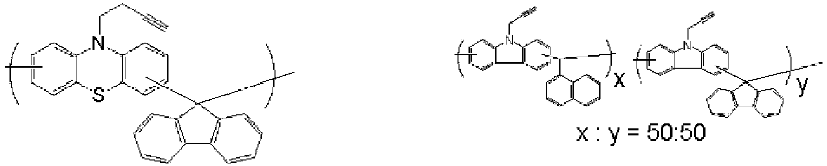

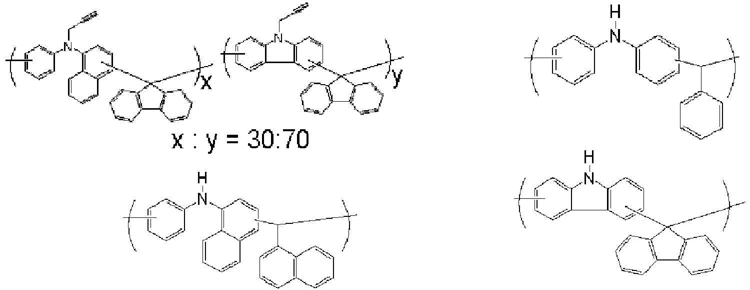

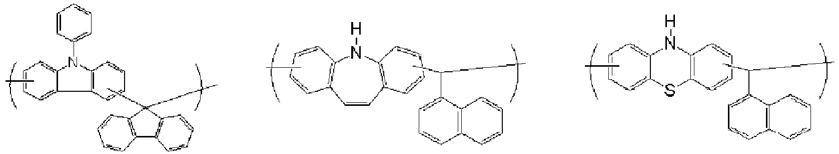

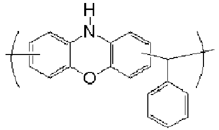

The material (A) for forming an organic film may be synthesized by a known method, and a commercially available product may be used.

The amount of the material (A) for forming an organic film to be contained is not particularly limited as long as sufficient film-formability can be achieved on spin-coating with the composition for forming an organic film, but the material (A) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the material for forming an organic film needs to be large. However, on the other hand, such a composition for forming an organic film is highly viscous, and in-plane uniformity after spin-coating and filling property are degraded. Even when the material (A) for forming an organic film is contained in such a proportion, the inventive composition for forming an organic film makes it possible to form an organic film having excellent in-plane uniformity and excellent filling property, and can therefore be applied suitably.

Meanwhile, the polymer (B) is preferably contained in an amount of 0.01 parts by mass to 5 parts by mass based on 100 parts by mass of the material (A) for forming an organic film. A composition for forming an organic film containing the polymer in such an amount makes it possible to form an organic film with better in-plane uniformity.

### [Solvent (C)]

The solvent (C) usable for the inventive composition for forming an organic film is not particularly limited as long as the solvent can dissolve the resin and/or compound (A) for forming an organic film and the polymer (B), and the solvent can preferably also dissolve the acid generator, crosslinking agent, surfactant, etc. described later. Specifically, it is possible to use a solvent having a boiling point lower than 180°C, such as the solvents disclosed in paragraphs (0091) and (0092) of JP 2007-199653 A. In particular, preferable solvents are propylene glycol monomethyl ether acetate, propylene glycol monomethyl ether, 2-heptanone, cyclopentanone, cyclohexanone, and mixtures of two or more thereof.

The solvent (C) is preferably contained in an amount of 200 to 10,000 parts by mass, more preferably 300 to 5,000 parts based on 100 parts by mass of the material (A) for forming an organic film. When the amount is in such a range, the concentration is adjustable in accordance with the desired film thickness.

Furthermore, the inventive composition for forming an organic film may also contain, as an organic solvent, a high-boiling-point solvent, having a boiling point of 180°C or higher, in addition to the above-described solvent having a boiling point of lower than 180°C (a mixture of a solvent having a boiling point of lower than 180°C and a solvent having a boiling point of 180°C or higher). The high-boiling-point organic solvent is not particularly limited to hydrocarbons, alcohols, ketones, esters, ethers, or chlorine-based solvents as long as the solvent is capable of dissolving the compound for forming an organic film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The boiling point of the high-boiling-point solvent can be selected appropriately in accordance with the temperature at which the composition for forming an organic film is heated, and the boiling point of the high-boiling-point solvent to be contained is preferably 180°C to 300°C, further preferably 200°C to 300°C. When the boiling point is as described, sufficient thermal flowability can be achieved, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent is used, the amount to be blended is preferably 1 to 30 parts by mass per 100 parts by mass of the solvent having a boiling point of lower than 180°C. When the contained amount is as described, and there is no risk that sufficient thermal flowability cannot be imparted at the time of baking due to the contained amount being too small, or that the solvent remains in the film and leads to degradation of physical properties, such as etching resistance, of the film due to the contained amount being too large.

The above-described composition for forming an organic film is provided with both high filling property and high planarizing property by thermal flowability being imparted to the material for forming an organic film by virtue of the high-boiling-point solvent being contained.

### [Other Components]

In addition, the inventive composition for forming an organic film can contain an acid generator or a crosslinking agent for further promoting the crosslinking reaction. Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the resin and/or compound (A) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the resin and/or compound (A) for forming an organic film. When the amount is as described, it is possible to enhance curability and further suppress intermixing with an upper layer film.

The inventive composition for forming an organic film can also contain a surfactant other than the inventive polymer (B) in order to further improve in-plane uniformity in spin-coating. Specific examples of the surfactant include those disclosed in paragraphs [0142] to [0147] of JP 2009-269953 A. One kind of the surfactant may be used, or two or more kinds thereof may be used in combination. When the surfactant is contained, the contained amount is preferably 0.01 to 10 parts by mass, more preferably 0.05 to 5 parts by mass based on 100 parts by mass of the resin and/or compound for forming an organic film. When the amount is as described, it is possible to form an organic film excellent in in-plane uniformity.

The inventive composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the resin and/or compound (A) for forming an organic film. When the amount is as described, it is possible to improve the storage stability of the composition for forming an organic film.

As described above, the inventive composition for forming an organic film is excellent in hump suppression at the time of an EBR process. Accordingly, the inventive composition for forming an organic film is extremely useful as a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including:
spin-coating a substrate to be processed with the inventive composition for forming an organic film described above; and
forming a cured film by heating the substrate coated with the composition for forming an organic film at a temperature of 100°C or higher and 600°C or lower for 10 to 600 seconds. For example, an organic film is formed by heating a substrate coated with the composition for forming an organic film at the temperature and time in the above ranges to cure the composition.

In this method for forming an organic film, firstly, the inventive composition for forming an organic film described above is applied onto a substrate to be processed by spin-coating. An excellent filling property can be obtained by using a spin-coating method. After removing a film on an edge portion in an EBR process, baking (heating) is performed in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds. Considering influence on device damage and wafer deformation, the upper limit of the heating temperature in a wafer process of lithography is preferably 600°C or lower, more preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic film on a body to be processed by using the above-described composition for forming an organic film;
forming a resist middle layer film on the organic film by using a resist middle layer film material containing a silicon atom;
forming a resist upper layer film on the resist middle layer film by using a resist upper layer film material containing a photoresist composition;
forming a circuit pattern in the resist upper layer film;
transferring the pattern to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film. The body to be processed is not particularly limited, but more specifically, may be a substrate made of Si, α-Si, p-Si, SiO₂, SiN, SiON, W, TiN, Al, etc.;
the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, particularly preferably 100 to 5,000 nm. Note that when the layer to be processed is formed, the substrate and the layer to be processed are formed from different materials.

The metal constituting the body to be processed preferably contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When an organic film is formed on the body to be processed by using the inventive composition for forming an organic film, the inventive method for forming an organic film described above can be adopted.

Subsequently, a resist middle layer film (silicon-containing resist middle layer film) is formed on the organic film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, when a material containing many aromatic groups and having high etching selectivity relative to the substrate is used as a composition for forming an organic film, the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has an anthryl group for 248-nm or 157-nm light exposure, or a phenyl group or a light-absorbing group having a silicon-silicon bond for 193-nm light exposure in a pendant structure, and which is to be crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, a silicon-containing resist middle layer film pattern is formed.

Subsequently, the pattern is transferred to the organic film by etching while using the silicon-containing resist middle layer film having the transferred pattern as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, an organic film pattern is formed.

Subsequently, the pattern is transferred to the body to be processed by etching while using the organic film having the transferred pattern as a mask. This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the silicon-containing resist middle layer film pattern is removed when the substrate is processed. Meanwhile, when the substrate is processed by etching with a chlorine- or bromine-based gas, the silicon-containing resist middle layer film pattern needs to be removed by additional dry etching with a fluorocarbon-based gas after the processing of the substrate.

The organic film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention provides the following patterning process.

A patterning process including:
forming an organic film on a body to be processed by using the above-described composition for forming an organic film;
forming a resist middle layer film on the organic film by using a resist middle layer film material containing a silicon atom;
forming an organic antireflective film or an adhesive film on the resist middle layer film;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention provides the following patterning process.

A patterning process including:
forming an organic film on a body to be processed by using the above-described composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a resist upper layer film material containing a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic film.

The inorganic hard mask middle layer film selected from the group consisting of a silicon oxide film, a silicon nitride film, and a silicon oxynitride film (SiON film) can be formed by a CVD method, an ALD method, etc. Examples of methods for forming the silicon nitride film are disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention provides the following patterning process.

A patterning process including:
forming an organic film on a body to be processed by using the above-described composition for forming an organic film;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

This method can be performed in the same manner as the three-layer resist process using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

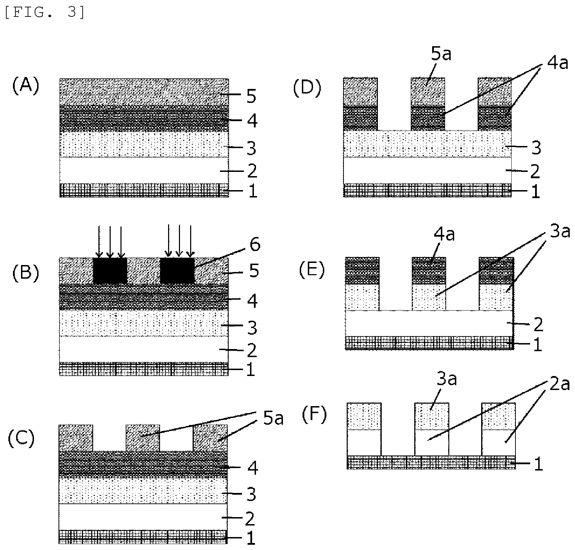

Here, an example of the inventive patterning processes according to a three-layer resist process is shown in FIG. 3 (A) to (F). In the case of a three-layer resist process, as shown in FIG. 3 (A), an organic film 3 is formed by using the inventive composition for forming an organic film on a layer 2 to be processed formed on a substrate 1; then, a silicon-containing resist middle layer film 4 is formed; and a resist upper layer film 5 is formed thereon. Next, as shown in FIG. 3 (B), an exposure portion 6 of the resist upper layer film 5 is exposed, and then PEB (post-exposure baking) is performed. Next, as shown in FIG. 3 (C), development is performed to form a resist upper layer film pattern 5a. Next, as shown in FIG. 3 (D), the silicon-containing resist middle layer film 4 is dry-etched by using a fluorocarbon-based gas while using the resist upper layer film pattern 5a as a mask, and thus, a silicon-containing resist middle layer film pattern 4a is formed. Next, as shown in FIG. 3 (E), the resist upper layer film pattern 5a is removed, then, the organic film 3 is etched with oxygen plasma while using the silicon-containing resist middle layer film pattern 4a as a mask, and thus, an organic film pattern 3a is formed. Furthermore, as shown in FIG. 3 (F), the silicon-containing resist middle layer film pattern 4a is removed, then the layer 2 to be processed is etched while using the organic film pattern 3a as a mask, and thus, a pattern 2a is formed. By humps being suppressed when the organic film is formed, during the dry etching of the drawings (D), (E), and (F), it is possible to reduce defects that are generated due to humps of the organic film.

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress the formation of humps of an organic film, thus reducing defects derived from the humps of the organic film.

### EXAMPLES

Hereinafter, the present invention will be further specifically described with reference to Synthesis Examples, Comparative Synthesis Examples, Examples, and Comparative Examples. However, the present invention is not limited thereto.

Specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Polymers (A1) to (A14)]

For the synthesis of compounds (A1) to (A14), used for the preparation of compositions for forming an organic film, the diol-based compounds (B1) and (B2) and oxetane compounds (B4) to (B14) shown below were used.

### Diol-Based Compound and Alcohol Compound

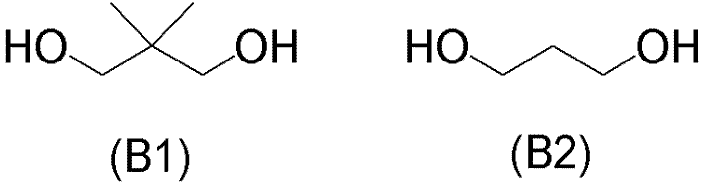

### Oxetane Compound

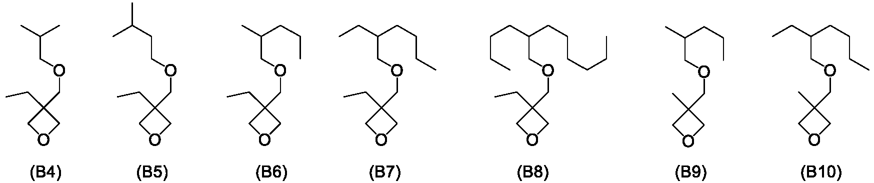

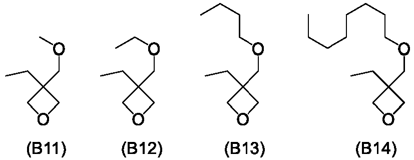

### [Synthesis Example 1] Synthesis of Ether Compound (A1)

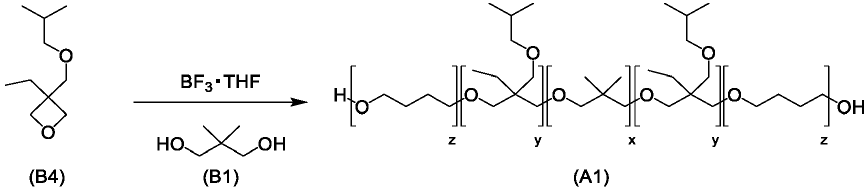

To 0.30 g of the diol-based compound (B1) and 0.24 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B4) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A1) was obtained.

The weight-average molecular weight (Mw) and the dispersity (Mw/Mn) were determined by GPC, and the following results were obtained.
(A1): Mw=3500, Mw/Mn=1.58

### [Synthesis Example 2] Synthesis of Ether Compound (A2)

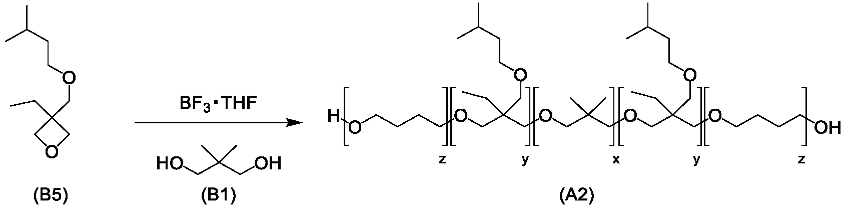

To 0.30 g of the diol-based compound (B1) and 0.23 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B5) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A2) was obtained.

The weight-average molecular weight (Mw) and the dispersity (Mw/Mn) were determined by GPC, and the following results were obtained.
(A2): Mw=3800, Mw/Mn=1.81

### [Synthesis Example 3] Synthesis of Ether Compound (A3)

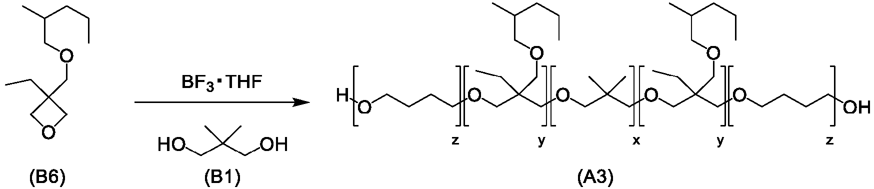

To 0.87 g of the diol-based compound (B1) and 0.21 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B6) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A3) was obtained.

The weight-average molecular weight (Mw) and the dispersity (Mw/Mn) were determined by GPC, and the following results were obtained.
(A3): Mw=2100, Mw/Mn=1.62

### [Synthesis Example 4] Synthesis of Ether Compound (A4)

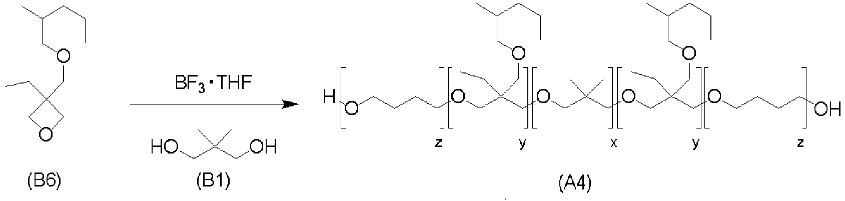

To 0.40 g of the diol-based compound (B1) and 0.21 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B6) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A4) was obtained.

The weight-average molecular weight (Mw) and the dispersity (Mw/Mn) were determined by GPC, and the following results were obtained.
(A4): Mw=2900, Mw/Mn=1.67

### [Synthesis Example 5] Synthesis of Ether Compound (A5)

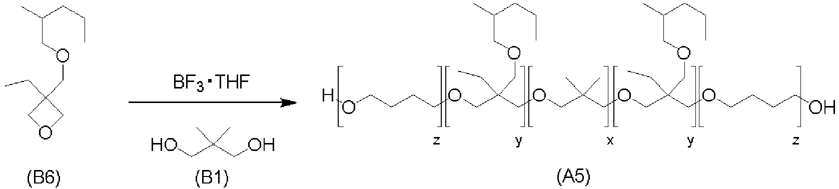

To 0.26 g of the diol-based compound (B1) and 0.21 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B6) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A5) was obtained.

The weight-average molecular weight (Mw) and the dispersity (Mw/Mn) were determined by GPC, and the following results were obtained.
(A5): Mw=3700, Mw/Mn=1.75

### [Synthesis Example 6] Synthesis of Ether Compound (A6)

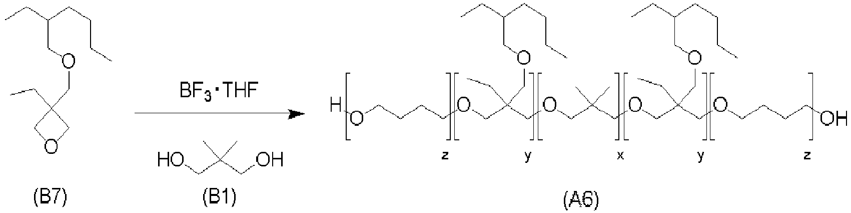

To 0.23 g of the diol-based compound (B1) and 0.18 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B7) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A6) was obtained.

The weight-average molecular weight (Mw) and the dispersity (Mw/Mn) were determined by GPC, and the following results were obtained.
(A6): Mw=3900, Mw/Mn=1.64

### [Synthesis Example 7] Synthesis of Ether Compound (A7)

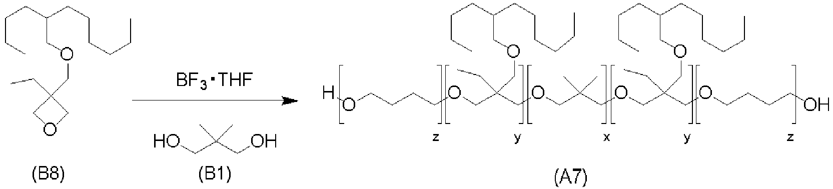

To 0.18 g of the diol-based compound (B1) and 0.15 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B8) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A7) was obtained.

The weight-average molecular weight (Mw) and the dispersity (Mw/Mn) were determined by GPC, and the following results were obtained.
(A7): Mw=4200, Mw/Mn=1.85

### [Synthesis Example 8] Synthesis of Ether Compound (A8)

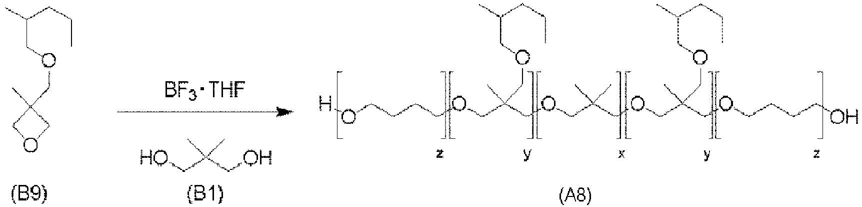

To 0.28 g of the diol-based compound (B1) and 0.23 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B9) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A8) was obtained.

The weight-average molecular weight (Mw) and the dispersity (Mw/Mn) were determined by GPC, and the following results were obtained.
(A8): Mw=3600, Mw/Mn=1.67

### [Synthesis Example 9] Synthesis of Ether Compound (A9)

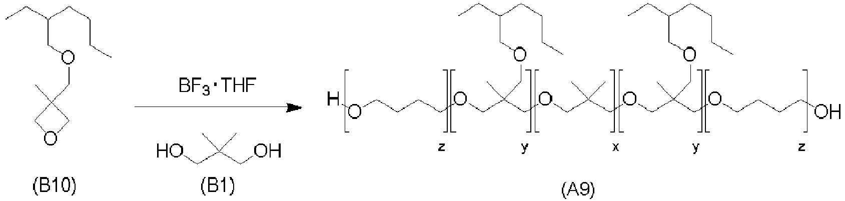

To 0.24 g of the diol-based compound (B1) and 0.20 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B10) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A9) was obtained.

The weight-average molecular weight (Mw) and the dispersity (Mw/Mn) were determined by GPC, and the following results were obtained.
(A9): Mw=3800, Mw/Mn=1.83

### [Synthesis Example 10] Synthesis of Ether Compound (A10)

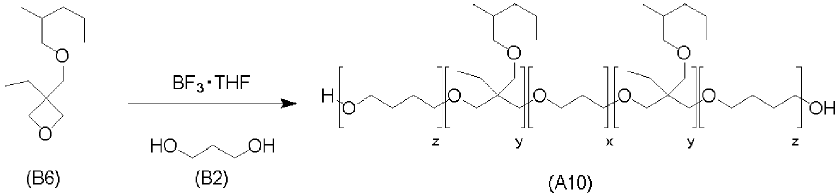

To 0.19 g of the diol-based compound (B2) and 0.21 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B6) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A10) was obtained.

The weight-average molecular weight (Mw) and the dispersity (Mw/Mn) were determined by GPC, and the following results were obtained.
(A10): Mw=3700, Mw/Mn=1.78

### [Synthesis Example 11] Synthesis of Ether Compound (A11)

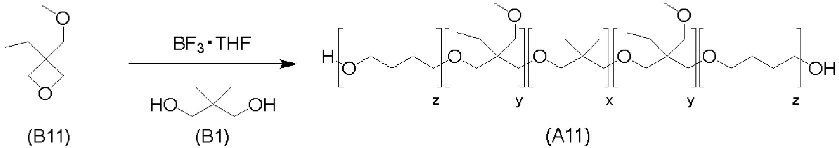

To 0.40 g of the diol-based compound (B1) and 0.32 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B11) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A11) was obtained.

The weight-average molecular weight (Mw) and the dispersity (Mw/Mn) were determined by GPC, and the following results were obtained.
(A11): Mw=3400, Mw/Mn=1.82

### [Synthesis Example 12] Synthesis of Ether Compound (A12)

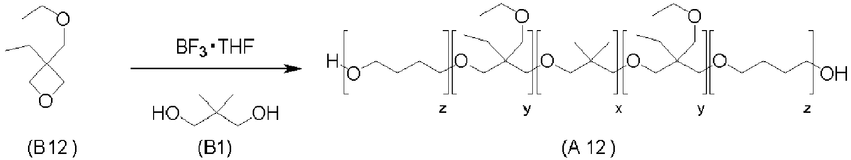

To 0.36 g of the diol-based compound (B1) and 0.29 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B12) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A12) was obtained.

The weight-average molecular weight (Mw) and the dispersity (Mw/Mn) were determined by GPC, and the following results were obtained.
(A12): Mw=3600, Mw/Mn=1.63

### [Synthesis Example 13] Synthesis of Ether Compound (A13)

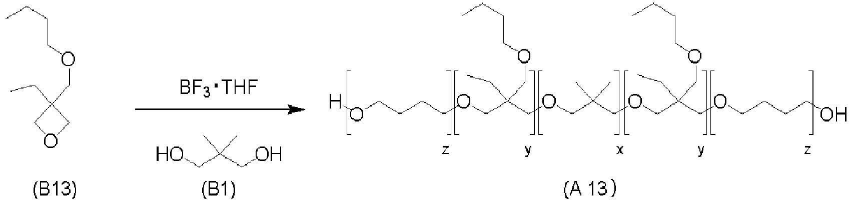

To 0.30 g of the diol-based compound (B1) and 0.24 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B13) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A13) was obtained.

The weight-average molecular weight (Mw) and the dispersity (Mw/Mn) were determined by GPC, and the following results were obtained.
(A13): Mw=3500, Mw/Mn=1.59

### [Synthesis Example 14] Synthesis of Ether Compound (A14)

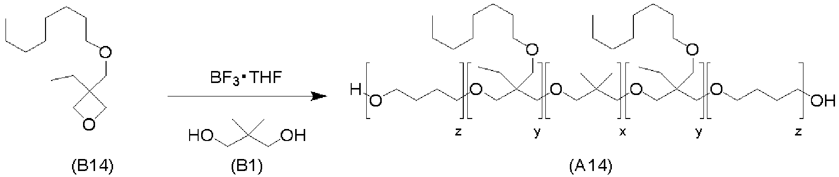

To 0.23 g of the diol-based compound (B1) and 0.18 g of boron trifluoride tetrahydrofuran, 10.0 g of methylene chloride was added, and under a nitrogen atmosphere, the mixture was stirred at a room temperature of 25°C for 30 minutes to form a homogeneous solution. After that, 10.0 g of the oxetane compound (B14) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, an ether compound (A14) was obtained.

The weight-average molecular weight (Mw) and the dispersity (Mw/Mn) were determined by GPC, and the following results were obtained.
(A14): Mw=3900, Mw/Mn=1.75

### [Synthesis of Comparative Compounds (R1) to (R3)]

For the synthesis of comparative compounds (R1) to (R3), used for the preparation of compositions for forming an organic film, the following monomers (B1), (B3), (B6), and (B11) were used.

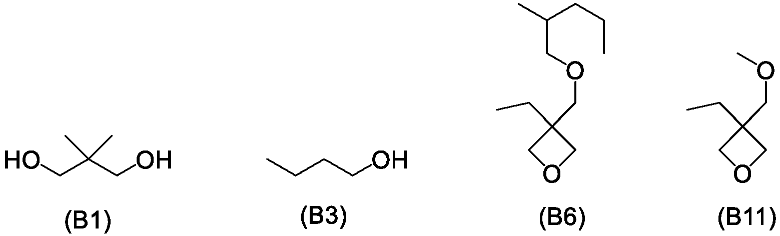

### [Comparative Synthesis Example 1] Synthesis of Comparative Compound (R1)

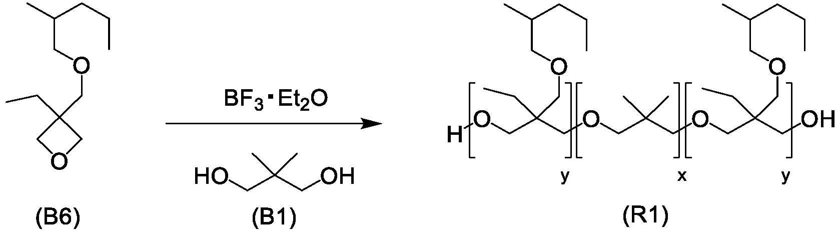

To 0.26 g of the diol-based compound (B1) and 0.21 g of boron trifluoride diethyl ether, 10.0 g of methylene chloride was added, and under a nitrogen atmosphere, the mixture was stirred at a room temperature of 25°C for 30 minutes to form a homogeneous solution. After that, 10.0 g of the oxetane compound (B6) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, a comparative compound (R1) was obtained.

The weight-average molecular weight (Mw) and the dispersity (Mw/Mn) were determined by GPC, and the following results were obtained.
(R1): Mw=4100, Mw/Mn=1.82

### [Comparative Synthesis Example 2] Synthesis of Comparative Compound (R2)

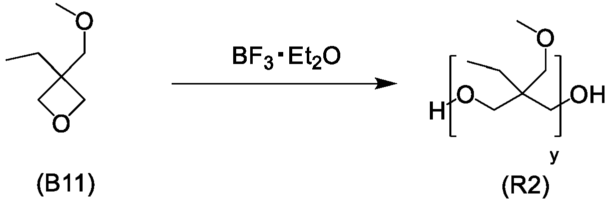

To 0.33 g of boron trifluoride diethyl ether, 10.0 g of methylene chloride was added, and under a nitrogen atmosphere, the mixture was stirred at a room temperature of 25°C to form a homogeneous solution. After that, 10.0 g of the oxetane compound (B11) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, a comparative compound (R2) was obtained.

The weight-average molecular weight (Mw) and the dispersity (Mw/Mn) were determined by GPC, and the following results were obtained.
(R2): Mw=61200, Mw/Mn=2.71

### [Comparative Synthesis Example 3] Synthesis of Comparative Compound (R3)

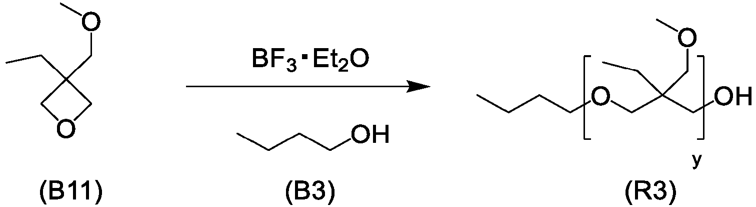

To 0.71 g of the alcohol-based compound (B3) and 0.33 g of boron trifluoride diethyl ether, 10.0 g of methylene chloride was added, and under a nitrogen atmosphere, the mixture was stirred at a room temperature of 25°C to form a homogeneous solution. After that, 10.0 g of the oxetane compound (B11) was added dropwise thereto over 5 minutes, and then a reaction was allowed to take place at a room temperature of 25°C for 3 hours. After the reaction, 50 ml of methylene chloride and 50 ml of pure water were added to the reaction solution and homogenized, and then the separated aqueous layer was removed. Furthermore, the organic layer was washed twice with 50 ml of a saturated sodium hydrogencarbonate solution and five times with 50 ml of pure water, and then the organic layer was evaporated under reduced pressure to dryness. Thus, a comparative compound (R3) was obtained.

The weight-average molecular weight (Mw) and the dispersity (Mw/Mn) were determined by GPC, and the following results were obtained.
(R3): Mw=7600, Mw/Mn=3.32

### [Material (Resin or Compound) for Forming Organic Film]

M1: a resin represented by the following formula (M1)
M2: a resin represented by the following formula (M2)
M3: a compound represented by the following formula (M3)
M4: a compound represented by the following formula (M4)
M5: a resin represented by the following formula (M5)
M6: a resin represented by the following formula (M6)

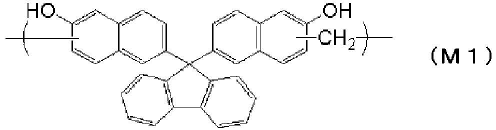

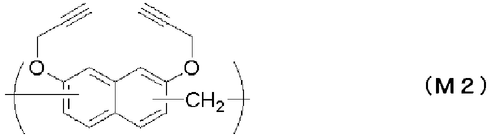

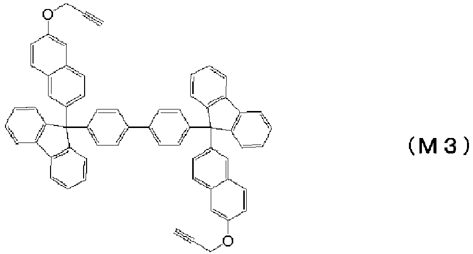

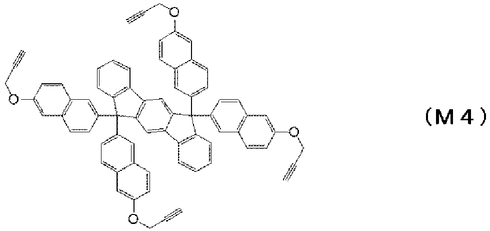

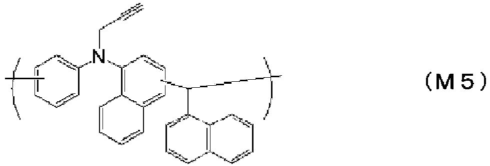

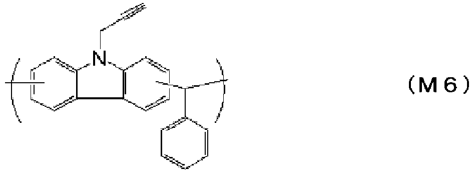

### [Solvent]

(S1): propylene glycol monomethyl ether acetate (PGMEA)
(S2): propylene glycol monoethyl ether

### [Preparation of Compositions (UDL-1 to -46 and Comparative UDL-1 to -14) for Forming Organic Film]

One of the compounds (A1) to (A14) and (R1) to (R3) and one of the materials (M1) to (M6) for forming an organic film, and the solvent were dissolved in the proportions shown in Table 1 and Table 2, and the mixture was filtered through a 0.1-µm filter made of a fluorinated resin to prepare each of compositions (resist underlayer film materials: UDL-1 to -46 and comparative UDL-1 to -14) for forming an organic film.

**[Table 1]**

| Composition for forming organic film | Resin for forming organic film | | Compound | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (M1) | 10.00 | (A1) | 0.10 | (S1) | 89.90 | | |
| UDL-2 | (M1) | 10.00 | (A2) | 0.10 | (S1) | 89.90 | | |
| UDL-3 | (M1) | 10.00 | (A3) | 0.10 | (S1) | 89.90 | | |
| UDL-4 | (M1) | 10.00 | (A4) | 0.10 | (S1) | 89.90 | | |
| UDL-5 | (M1) | 10.00 | (A5) | 0.10 | (S1) | 89.90 | | |
| UDL-6 | (M1) | 10.00 | (A6) | 0.10 | (S1) | 89.90 | | |
| UDL-7 | (M1) | 10.00 | (A7) | 0.10 | (S1) | 89.90 | | |
| UDL-8 | (M2) | 10.00 | (A8) | 0.10 | (S1) | 89.90 | | |
| UDL-9 | (M2) | 10.00 | (A9) | 0.10 | (S1) | 89.90 | | |
| UDL-10 | (M2) | 10.00 | (A10) | 0.10 | (S1) | 89.90 | | |
| UDL-11 | (M2) | 10.00 | (A11) | 0.10 | (S1) | 89.90 | | |
| UDL-12 | (M2) | 10.00 | (A12) | 0.10 | (S1) | 89.90 | | |
| UDL-13 | (M2) | 10.00 | (A13) | 0.10 | (S1) | 89.90 | | |
| UDL-14 | (M2) | 10.00 | (A14) | 0.10 | (S1) | 89.90 | | |
| UDL-15 | (M3) | 10.00 | (A1) | 0.10 | (S1) | 89.90 | | |
| UDL-16 | (M3) | 10.00 | (A2) | 0.10 | (S1) | 89.90 | | |
| UDL-17 | (M3) | 10.00 | (A3) | 0.10 | (S1) | 89.90 | | |
| UDL-18 | (M3) | 10.00 | (A4) | 0.10 | (S1) | 89.90 | | |
| UDL-19 | (M3) | 10.00 | (A5) | 0.10 | (S1) | 89.90 | | |
| UDL-20 | (M3) | 10.00 | (A6) | 0.10 | (S1) | 89.90 | | |
| UDL-21 | (M3) | 10.00 | (A7) | 0.10 | (S1) | 89.90 | | |
| UDL-22 | (M4) | 10.00 | (A8) | 0.10 | (S1) | 89.90 | | |
| UDL-23 | (M4) | 10.00 | (A9) | 0.10 | (S1) | 89.90 | | |
| UDL-24 | (M4) | 10.00 | (A10) | 0.10 | (S1) | 89.90 | | |
| UDL-25 | (M4) | 10.00 | (A11) | 0.10 | (S1) | 89.90 | | |
| UDL-26 | (M4) | 10.00 | (A12) | 0.10 | (S1) | 89.90 | | |
| UDL-27 | (M4) | 10.00 | (A13) | 0.10 | (S1) | 89.90 | | |
| UDL-28 | (M4) | 10.00 | (A14) | 0.10 | (S1) | 89.90 | | |
| UDL-29 | (M5) | 10.00 | (A1) | 0.10 | (S1) | 89.90 | | |
| UDL-30 | (M5) | 10.00 | (A2) | 0.10 | (S1) | 89.90 | | |
| UDL-31 | (M5) | 10.00 | (A3) | 0.10 | (S1) | 89.90 | | |
| UDL-32 | (M5) | 10.00 | (A4) | 0.10 | (S1) | 89.90 | | |
| UDL-33 | (M5) | 10.00 | (A5) | 0.10 | (S1) | 89.90 | | |
| UDL-34 | (M5) | 10.00 | (A6) | 0.10 | (S1) | 89.90 | | |
| UDL-35 | (M5) | 10.00 | (A7) | 0.10 | (S1) | 89.90 | | |
| UDL-36 | (M6) | 10.00 | (A8) | 0.10 | (S1) | 89.90 | | |

**[Table 2]**

| Composition for forming organic film | Resin for forming organic film | | Compound | | Solvent 1 | | Solvent 2 | |
|---|---|---|---|---|---|---|---|---|
| | Type | Parts bymass | Type | Parts by mass | Type | Parts by mass | Type | Parts by mass |
| UDL-37 | (M6) | 10.00 | (A9) | 0.10 | (S1) | 89.90 | | |
| UDL-38 | (M6) | 10.00 | (A10) | 0.10 | (S1) | 89.90 | | |
| UDL-39 | (M6) | 10.00 | (A11) | 0.10 | (S1) | 89.90 | | |
| UDL-40 | (M6) | 10.00 | (A12) | 0.10 | (S1) | 89.90 | | |
| UDL-41 | (M6) | 10.00 | (A13) | 0.10 | (S1) | 89.90 | | |
| UDL-42 | (M6) | 10.00 | (A14) | 0.10 | (S1) | 89.90 | | |
| UDL-43 | (M1) | 10.00 | (A1) | 0.10 | (S1) | 62.93 | (S2) | 26.97 |
| UDL-44 | (M1) | 10.00 | (A2) | 0.10 | (S1) | 62.93 | (S2) | 26.97 |
| UDL-45 | (M1) | 10.00 | (A3) | 0.10 | (S1) | 62.93 | (S2) | 26.97 |
| UDL-46 | (M1) | 10.00 | (A4) | 0.10 | (S1) | 62.93 | (S2) | 26.97 |
| Comparative UDL-1 | (M1) | 10.00 | (R1) | 0.10 | (S1) | 89.90 | | |
| Comparative UDL-2 | (M2) | 10.00 | (R1) | 0.10 | (S1) | 89.90 | | |
| Comparative UDL-3 | (M3) | 10.00 | (R1) | 0.10 | (S1) | 89.90 | | |
| Comparative UDL-4 | (M4) | 10.00 | (R1) | 0.10 | (S1) | 89.90 | | |
| Comparative UDL-5 | (M5) | 10.00 | (R1) | 0.10 | (S1) | 89.90 | | |
| Comparative UDL-6 | (M6) | 10.00 | (R1) | 0.10 | (S1) | 89.90 | | |
| Comparative UDL-7 | (M1) | 10.00 | (R2) | 0.10 | (S1) | 89.90 | | |
| Comparative UDL-8 | (M1) | 10.00 | (R3) | 0.10 | (S1) | 89.90 | | |
| Comparative UDL-9 | (M1) | 10.00 | | | (S1) | 89.90 | | |
| Comparative UDL-10 | (M2) | 10.00 | | | (S1) | 89.90 | | |
| Comparative UDL-11 | (M3) | 10.00 | | | (S1) | 89.90 | | |
| Comparative UDL-12 | (M4) | 10.00 | | | (S1) | 89.90 | | |
| Comparative UDL-13 | (M5) | 10.00 | | | (S1) | 89.90 | | |
| Comparative UDL-14 | (M6) | 10.00 | | | (S1) | 90.00 | | |

### [Preparation of Silicon Wafers Having Cured Organic Film Formed Thereon By Using Compositions (UDL-1 to -46 and Comparative UDL-1 to -14) for Forming Organic Film]

Using a coater/developer "CLEAN TRACK LITHIUS Pro AP" of Tokyo Electron Ltd., each of the compositions (UDL-1 to -46 and comparative UDL-1 to -14) for forming an organic film prepared above was respectively discharged in an amount of 2 ml onto a silicon wafer at the center. Then, the wafer was rotated at a rotational rate to achieve, after baking, the average film thickness shown in Tables 3 and 4 to spread the composition. Thus, a film was formed. While rotating the silicon wafer at a rate of 1000 rpm, the remover-discharging nozzle was moved at a speed of 5 mm/s from the periphery of the silicon wafer to a position 3 mm from the center while discharging a remover (mixed solution of propylene glycol monomethyl ether acetate (S1) and propylene glycol monomethyl ether (S2) (30:70, mass ratio)) at a discharge rate of 2 ml/s, and the remover was further discharged at that position for 5 seconds at a discharge rate of 2 ml/s. After that, the discharging of the discharged liquid was terminated, and the silicon wafer was further rotated at a rate of 1000 rpm for 30 seconds. Next, the silicon wafer having the film of the composition for forming an organic film formed thereon was heated at 350°C for 60 seconds. Thus, silicon wafers having a cured organic film formed were obtained.

### [Solvent Resistance Evaluation: Examples 1-1 to 1-46 and Comparative Examples 1-1 to 1-14]

A film was formed on a silicon wafer according to the above-described method by using each of the compositions (UDL-1 to -46 and comparative UDL-1 to -14) for forming an organic film, and the thickness of the film was measured. Subsequently, a PGMEA solvent was dispensed on the film, left to stand for 30 seconds, spin-dried, and baked at 100°C for 60 seconds to evaporate the PGMEA, and then the thickness of the film was measured. The absolute value of the value determined by (X₁-X)/X × 100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 3 and 4 show the results.

### [In-Plane Uniformity Evaluation: Examples 1-1 to 1-46 and Comparative Examples 1-1 to 1-14]

A film was formed on a silicon wafer according to the above-described method by using each of the compositions (UDL-1 to -46 and comparative UDL-1 to -14) for forming an organic film, and the film thickness within a radius of 145 mm from the center of the cured organic film was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 2%, the composition was evaluated as A (good), when 2% or more to less than 3%, B, and when 3% or more, C (poor). Tables 3 and 4 show the results.

**[Table 3]**

| | Composition for forming organic film | Average film thickness | Solvent resistance | In-plane uniformity |
|---|---|---|---|---|
| Example 1-1 | UDL-1 | 500 nm | Good | A |
| Example 1-2 | UDL-2 | 500 nm | Good | A |
| Example 1-3 | UDL-3 | 500 nm | Good | A |
| Example 1-4 | UDL-4 | 500 nm | Good | A |
| Example 1-5 | UDL-5 | 500 nm | Good | A |
| Example 1-6 | UDL-6 | 500 nm | Good | B |
| Example 1-7 | UDL-7 | 500 nm | Good | A |
| Example 1-8 | UDL-8 | 500 nm | Good | B |
| Example 1-9 | UDL-9 | 500 nm | Good | A |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | A |
| Example 1-17 | UDL-17 | 500 nm | Good | A |
| Example 1-18 | UDL-18 | 500 nm | Good | B |
| Example 1-19 | UDL-19 | 500 nm | Good | A |
| Example 1-20 | UDL-20 | 500 nm | Good | A |
| Example 1-21 | UDL-21 | 500 nm | Good | A |
| Example 1-22 | UDL-22 | 500 nm | Good | B |
| Example 1-23 | UDL-23 | 500 nm | Good | B |
| Example 1-24 | UDL-24 | 500 nm | Good | A |
| Example 1-25 | UDL-25 | 500 nm | Good | A |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | A |
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |
| Example 1-36 | UDL-36 | 500 nm | Good | A |
| Example 1-37 | UDL-37 | 500 nm | Good | A |

**[Table 4]**

| | Composition for forming organic film | Average film thickness | Solvent resistance | In-plane uniformity |
|---|---|---|---|---|
| Example 1-38 | UDL-38 | 500 nm | Good | A |
| Example 1-39 | UDL-39 | 500 nm | Good | A |
| Example 1-40 | UDL-40 | 500 nm | Good | B |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Comparative Example 1-1 | Comparative UDL-1 | 500 nm | Good | B |
| Comparative Example 1-2 | Comparative UDL-2 | 500 nm | Good | B |
| Comparative Example 1-3 | Comparative UDL-3 | 500 nm | Good | B |
| Comparative Example 1-4 | Comparative UDL-4 | 500 nm | Good | B |
| Comparative Example 1-5 | Comparative UDL-5 | 500 nm | Good | B |
| Comparative Example 1-6 | Comparative UDL-6 | 500 nm | Good | B |
| Comparative Example 1-7 | Comparative UDL-7 | 500 nm | Good | B |
| Comparative Example 1-8 | Comparative UDL-8 | 500 nm | Good | B |
| Comparative Example 1-9 | Comparative UDL-9 | 500 nm | Good | C |
| Comparative Example 1-10 | Comparative UDL-10 | 500 nm | Good | C |
| Comparative Example 1-11 | Comparative UDL-11 | 500 nm | Good | C |
| Comparative Example 1-12 | Comparative UDL-12 | 500 nm | Good | C |
| Comparative Example 1-13 | Comparative UDL-13 | 500 nm | Good | C |
| Comparative Example 1-14 | Comparative UDL-14 | 500 nm | Good | C |

As shown in Tables 3 and 4, an organic film excellent in both solvent resistance and in-plane uniformity was obtained (evaluation A or evaluation B) in Examples 1-1 to 1-46, where used was a composition for forming an organic film containing, as the component (B), the inventive polymer, not containing a halogen atom and containing a repeating unit represented by the formula (1) and a repeating unit represented by the formula (1'), and in Comparative Examples 1-1 to 1-8, where a polymer similar to the inventive polymer was contained. On the other hand, in-plane uniformity was poor (evaluation C) in Comparative Examples 1-9 to 1-14, where used was a composition not containing such a polymer as the component (B).

Regarding comparative UDL-1 to -8, which had both good solvent resistance and good in-plane uniformity in the above-described evaluations, and Examples 2-1 to 2-46 of the present invention, hump suppression property evaluation, filling property evaluation, and silicon-containing middle layer film coating property evaluation were evaluated for the purpose of clarifying the difference in performance.

### [Hump Suppression Property Evaluation: Examples 2-1 to 2-46 and Comparative Examples 2-1 to 2-8]

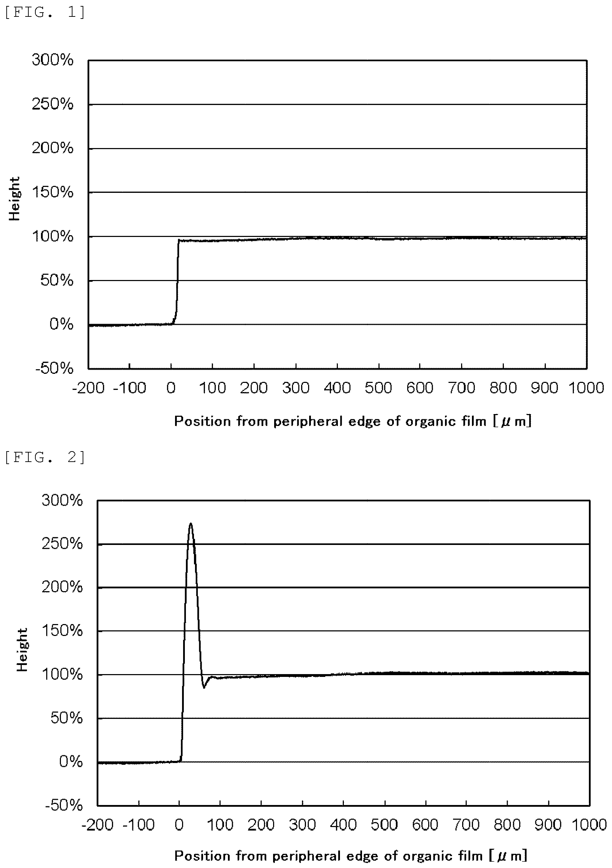

A film was formed on a silicon wafer according to the above-described method by using each of the compositions (UDL-1 to -46 and comparative UDL-1 to -8) for forming an organic film, and the variation in height from the peripheral edge of the organic film towards the center of the silicon wafer to a position of 1000 µm was measured by using Alpha-Step D-600 (a stylus profiler) manufactured by KLA corporation. The height of the silicon wafer was regarded as 0, and when the maximum height was less than 110% of the film thickness as shown in FIG. 1, the composition was evaluated as A (good), when the maximum height was 110% or more to less than 150%, B, and when a region where the height was 150% or more occurred as shown in FIG. 2, C (poor). Tables 5 and 6 show the results.

### [Filling Property Evaluation: Examples 2-1 to 2-46 and Comparative Examples 2-1 to 2-8]

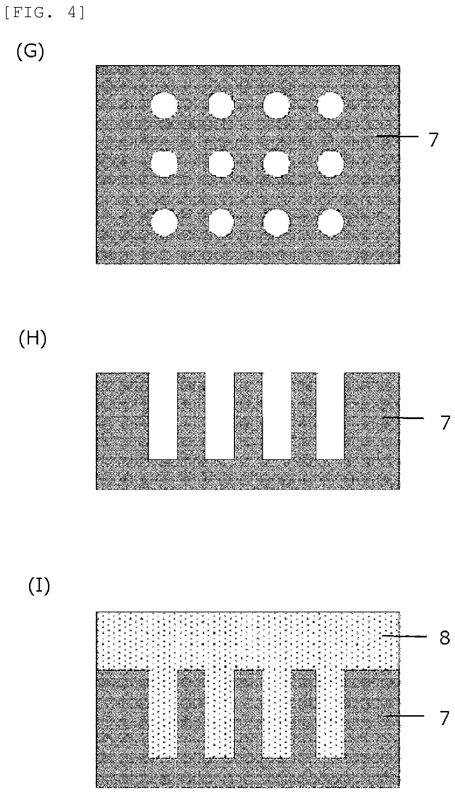

As shown in FIG. 4, a film of each of the compositions (UDL-1 to -46 and comparative UDL-1 to -8) for forming an organic film was respectively formed on an SiO₂ wafer substrate having a dense hole pattern (hole diameter 0.2 µm, hole depth 1.0 µm, distance between the centers of two adjacent holes 0.4 µm) according to the above-described method to form an organic film 8. The substrate used was a base substrate (SiO₂ wafer substrate) 7 having the dense hole pattern shown in FIG. 4 (G) (downward view) and (H) (cross-sectional view). The cross-sectional shape of each of the obtained wafer substrates was observed using a scanning electron microscope (SEM), and it was observed whether or not the inside of the holes was filled with the organic film without gaps. When an organic film material having poor filling property is used, gaps are generated inside the holes. When an organic film material having a desirable filling property is used in the present evaluation, the inside of the holes is filled with the organic film without gaps, as shown in FIG. 4 (I). The composition was evaluated as "Good" when no gaps were generated, and when gaps were generated, as "Poor". Tables 5 and 6 show the results.

### [Silicon-Containing Middle Layer Film Coating Property Evaluation: Examples 2-1 to 2-46 and Comparative Examples 2-1 to 2-8]

A cured organic film was formed respectively on a silicon wafer substrate by using each of the compositions (UDL-1 to -46 and comparative UDL-1 to -8) for forming an organic film according to the above-described method. The silicon-containing resist middle layer film material (SOG1) described below was applied to the cured organic film, and baking was performed at 200°C for 60 seconds to form a silicon-containing resist middle layer film. Then, the condition of the coating film of the silicon-containing resist middle layer film was visually observed and evaluated.

When the condition of the coating film was good, the composition was evaluated as "Good", and when dewetting had occurred, as "Poor".

Note that, in this evaluation, to evaluate whether the coatability of the silicon-containing middle layer film is excellent or not, the thickness of the silicon-containing middle layer film was set to 10 nm, and this is a severe evaluation condition. Tables 5 and 6 show the results.

As the silicon-containing resist middle layer film material (SOG1), a solution of the following polymer in propylene glycol ethyl ether was prepared. The polymer solution used in the silicon-containing middle layer film coating property evaluation was 0.5 mass%.

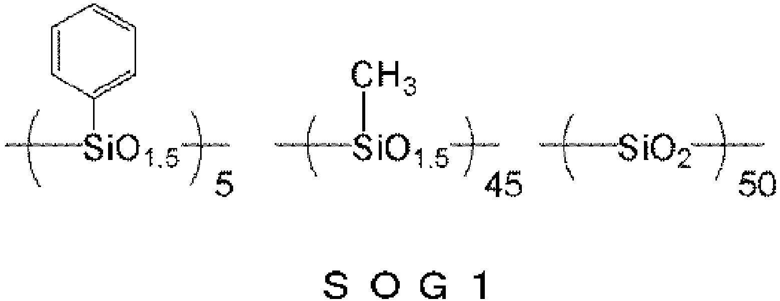

### [Contact Angle Evaluation: Examples 2-1 to 2-46 and Comparative Examples 2-1 to 2-8]

A cured organic film was formed respectively on a silicon wafer substrate by using each of the compositions (UDL-1 to -46 and comparative UDL-1 to -8) for forming an organic film according to the above-described method, and the contact angle with pure water was measured. Tables 5 and 6 show the results.

**[Table 5]**

| | Compositi on for forming organic film | Hump suppressio n property evaluation | Filling property evaluatio n | Silicon-containing middle layer film coating property evaluation | Contact angle evaluation |
|---|---|---|---|---|---|
| Example 2-1 | UDL-1 | A | Good | Good | 68° |
| Example 2-2 | UDL-2 | A | Good | Good | 68° |
| Example 2-3 | UDL-3 | A | Good | Good | 68° |
| Example 2-4 | UDL-4 | A | Good | Good | 66° |
| Example 2-5 | UDL-5 | A | Good | Good | 67° |
| Example 2-6 | UDL-6 | A | Good | Good | 67° |
| Example 2-7 | UDL-7 | A | Good | Good | 68° |
| Example 2-8 | UDL-8 | B | Good | Good | 65° |
| Example 2-9 | UDL-9 | A | Good | Good | 66° |
| Example 2-10 | UDL-10 | A | Good | Good | 68° |
| Example 2-11 | UDL-11 | A | Good | Good | 67° |
| Example 2-12 | UDL-12 | A | Good | Good | 67° |
| Example 2-13 | UDL-13 | A | Good | Good | 68° |
| Example 2-14 | UDL-14 | A | Good | Good | 66° |
| Example 2-15 | UDL-15 | A | Good | Good | 66° |
| Example 2-16 | UDL-16 | A | Good | Good | 67° |
| Example 2-17 | UDL-17 | A | Good | Good | 68° |
| Example 2-18 | UDL-18 | A | Good | Good | 66° |
| Example 2-19 | UDL-19 | A | Good | Good | 68° |
| Example 2-20 | UDL-20 | A | Good | Good | 68° |
| Example 2-21 | UDL-21 | A | Good | Good | 66° |
| Example 2-22 | UDL-22 | A | Good | Good | 67° |
| Example 2-23 | UDL-23 | B | Good | Good | 66° |
| Example 2-24 | UDL-24 | A | Good | Good | 67° |
| Example 2-25 | UDL-25 | A | Good | Good | 66° |
| Example 2-26 | UDL-26 | A | Good | Good | 68° |
| Example 2-27 | UDL-27 | A | Good | Good | 68° |
| Example 2-28 | UDL-28 | A | Good | Good | 67° |
| Example 2-29 | UDL-29 | A | Good | Good | 65° |
| Example 2-30 | UDL-30 | A | Good | Good | 65° |
| Example 2-31 | UDL-31 | A | Good | Good | 67° |
| Example 2-32 | UDL-32 | A | Good | Good | 66° |
| Example 2-33 | UDL-33 | A | Good | Good | 67° |
| Example 2-34 | UDL-34 | A | Good | Good | 66° |
| Example 2-35 | UDL-35 | A | Good | Good | 68° |
| Example 2-36 | UDL-36 | A | Good | Good | 67° |

**[Table 6]**

| | Composition for forming organic film | Hump suppression property evaluation | Filling property evaluation | Silicon-containing middle layer film coating property evaluation | Contact angle evaluation |
|---|---|---|---|---|---|
| Example 2-37 | UDL-37 | A | Good | Good | 67° |
| Example 2-38 | UDL-38 | A | Good | Good | 68° |
| Example 2-39 | UDL-39 | A | Good | Good | 66° |
| Example 2-40 | UDL-40 | A | Good | Good | 66° |
| Example 2-41 | UDL-41 | A | Good | Good | 67° |
| Example 2-42 | UDL-42 | A | Good | Good | 67° |
| Example 2-43 | UDL-43 | A | Good | Good | 68° |
| Example 2-44 | UDL-44 | A | Good | Good | 68° |
| Example 2-45 | UDL-45 | A | Good | Good | 68° |
| Example 2-46 | UDL-46 | A | Good | Good | 66° |
| Comparative Example 2-1 | Comparative UDL-1 | C | Poor | Poor | 73° |
| Comparative Example 2-2 | Comparative UDL-2 | C | Poor | Poor | 75° |
| Comparative Example 2-3 | Comparative UDL-3 | C | Poor | Poor | 72° |
| Comparative Example 2-4 | Comparative UDL-4 | C | Poor | Poor | 72° |
| Comparative Example 2-5 | Comparative UDL-5 | C | Poor | Poor | 72° |
| Comparative Example 2-6 | Comparative UDL-6 | C | Poor | Poor | 73° |
| Comparative Example 2-7 | Comparative UDL-7 | C | Poor | Poor | 57° |
| Comparative Example 2-8 | Comparative UDL-8 | C | Poor | Poor | 57° |

As shown in Tables 5 and 6, it was confirmed that the inventive compositions (UDL-1 to -46) for forming an organic film were excellent in hump suppression property, filling property, and the coating property of the silicon-containing middle layer film. Meanwhile, the contact angle was between 65° and 68°.

### [Patterning Test: Examples 3-1 to 3-42]

A cured organic film was formed respectively on an SiO₂ wafer substrate by using each of the compositions (UDL-1 to -42) for forming an organic film according to the above-described method. Subsequently, the silicon-containing resist middle layer film material (SOG1) described below was applied to the cured organic film, and baking was performed at 200°C for 60 seconds to form a 35-nm thick silicon-containing resist middle layer film. Subsequently, the monolayer resist for ArF described below was applied thereto as a resist upper layer film material and baked at 105°C for 60 seconds to form a 100-nm thick photoresist film. Subsequently, the liquid immersion top coat composition (TC-1) described below was applied to the photoresist film and baked at 90°C for 60 seconds to form a 50-nm thick top coat.

As the silicon-containing resist middle layer film material (SOG1), a 2% solution of the following polymer in propylene glycol ethyl ether was prepared.

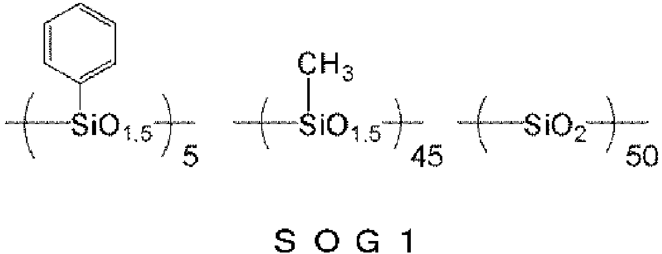

The resist upper layer film material (monolayer resist for ArF) was prepared by dissolving a polymer (RP1), an acid generator (PAG1), and a basic compound (Aminel), each in the proportion shown in Table 7, in a propylene glycol monomethyl ether acetate (PGMEA) solvent containing 0.1% by mass of FC-430 (manufactured by Sumitomo 3M Limited), and filtering the obtained mixture through a 0.1-µm filter made of a fluororesin.

**[Table 7]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Aminel (0.8) | PGMEA (2500) |

The polymer (RP1), the acid generator (PAG1), and the basic compound (Aminel) are shown below.

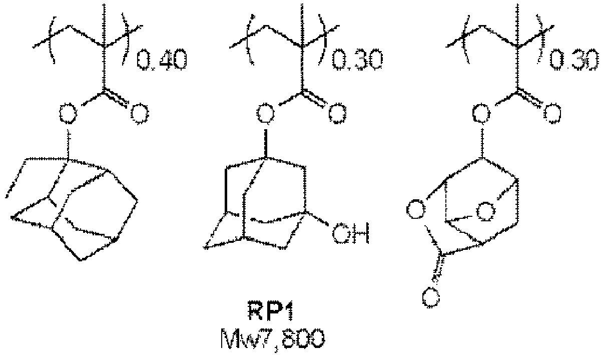

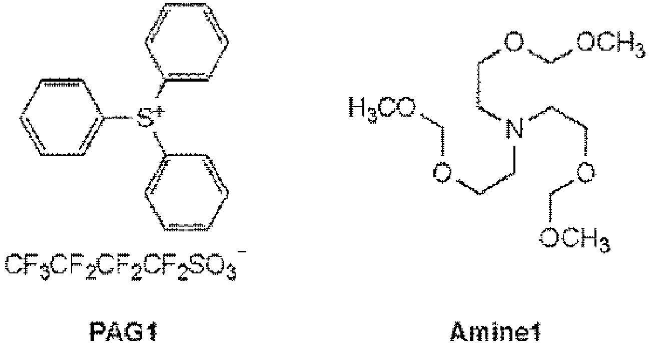

The liquid immersion top coat composition (TC-1) was prepared by dissolving a polymer (PP1) in an organic solvent at the proportion shown in Table 8, and filtering the obtained mixture through a 0.1-µm filter made of a fluororesin.

**[Table 8]**

| | Polymer (parts by mass) | Solvent (parts by mass) |
|---|---|---|
| TC-1 | PP1 (100) | Diisoamyl ether (2700) |
| | | 2-methyl-1-butanol (270) |

The polymer (PP1) is shown below.

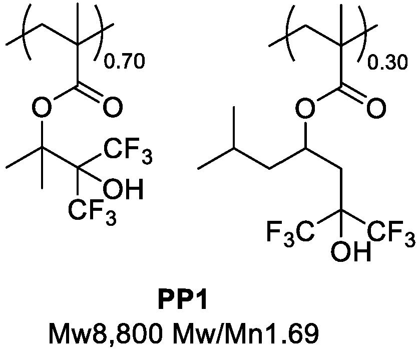

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, using an etching apparatus Telius manufactured by Tokyo Electron Ltd., the silicon-containing resist middle layer film was dry-etched (the pattern was transferred) while using the resist upper layer film pattern as a mask; the organic film was dry-etched (the pattern was transferred) while using the obtained silicon-containing resist middle layer film pattern as a mask; and the SiO₂ wafer substrate (SiO₂ film) was dry-etched (the pattern was transferred) while using the obtained organic film pattern as a mask. The etching conditions were as follows.

### Conditions in transferring resist upper layer film pattern to silicon-containing resist middle layer film

Chamber pressure: 10.0 Pa
RF-power: 1,500 W
CF₄ gas flow rate: 75 ml/min
O₂ gas flow rate: 15 ml/min
Time: 15 sec

### Conditions in transferring silicon-containing resist middle layer film pattern to organic film

Chamber pressure: 2.0 Pa
RF-power: 500 W
Ar gas flow rate: 75 ml/min
O₂ gas flow rate: 45 ml/min
Time: 120 sec

### Conditions in transferring organic film pattern to SiO₂ wafer substrate

Chamber pressure: 2.0 Pa
RF-power: 2,200 W
C₅F₁₂ gas flow rate: 20 ml/min
C₂F₆ gas flow rate: 10 ml/min
Ar gas flow rate: 300 ml/min
O₂ gas flow rate: 60 ml/min
Time: 90 sec

The cross section of the obtained pattern was observed with an electron microscope (S-4700) manufactured by Hitachi, Ltd. Table 9 show the results.

**[Table 9]**

| | Composition for forming organic film | Profile after etching for transferring to substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |

As shown in Table 9, in Examples 3-1 to 3-42, where the inventive compositions (UDL-1 to -42) for forming an organic film were used, the resist upper layer film pattern was successfully transferred to the SiO₂ wafer substrate in the end in every case. Thus, it was confirmed that the inventive compositions for forming an organic film can be used suitably for fine processing using a multilayer resist method.

### [Preparation of Resist Upper Layer Film Materials (ArFPR1 to 14 and Comparative ArFPR)]

Resist upper layer film materials (ArFPR1 to 14 and comparative ArFPR) were respectively prepared by dissolving each of the polymer (RP1), acid generator (PAG1), basic compound (Aminel), and one of the above-described compounds in a solvent in the proportions shown in Table 10, and filtering the obtained mixture through a 0.1-µm filter made of a fluororesin.

**[Table 10]**

| Resist upper layer film material | Polymer (parts by mass) | Acid generator (parts by mass) | Basic compound (parts by mass) | Compound (parts by mass) | Solvent (parts by mass) |
|---|---|---|---|---|---|
| ArFPR1 | RP1 (100) | PAG1 (6.6) | Aminel (0.8) | (A1) (2.5) | PGMEA (2500) |
| ArFPR2 | RP1 (100) | PAG1 (6.6) | Aminel (0.8) | (A2) (2.5) | PGMEA (2500) |
| ArFPR3 | RP1 (100) | PAG1 (6.6) | Aminel (0.8) | (A3) (2.5) | PGMEA (2500) |
| ArFPR4 | RP1 (100) | PAG1 (6.6) | Aminel (0.8) | (A4) (2.5) | PGMEA (2500) |
| ArFPR5 | RP1 (100) | PAG1 (6.6) | Aminel (0.8) | (A5) (2.5) | PGMEA (2500) |
| ArFPR6 | RP1 (100) | PAG1 (6.6) | Aminel (0.8) | (A6) (2.5) | PGMEA (2500) |
| ArFPR7 | RP1 (100) | PAG1 (6.6) | Aminel (0.8) | (A7) (2.5) | PGMEA (2500) |
| ArFPR8 | RP1 (100) | PAG1 (6.6) | Aminel (0.8) | (A8) (2.5) | PGMEA (2500) |
| ArFPR9 | RP1 (100) | PAG1 (6.6) | Aminel (0.8) | (A9) (2.5) | PGMEA (2500) |
| ArFPR10 | RP1 (100) | PAG1 (6.6) | Aminel (0.8) | (A10) (2.5) | PGMEA (2500) |
| ArFPR11 | RP1 (100) | PAG1 (6.6) | Aminel (0.8) | (A11) (2.5) | PGMEA (2500) |
| ArFPR12 | RP1 (100) | PAG1 (6.6) | Aminel (0.8) | (A12) (2.5) | PGMEA (2500) |
| ArFPR13 | RP1 (100) | PAG1 (6.6) | Aminel (0.8) | (A13) (2.5) | PGMEA (2500) |
| ArFPR14 | RP1 (100) | PAG1 (6.6) | Aminel (0.8) | (A14) (2.5) | PGMEA (2500) |
| Comparative ArFPR | RP1 (100) | PAG1 (6.6) | Aminel (0.8) | - | PGMEA (2500) |

### [Preparation of Silicon Wafers Having Resist Upper Layer Film Formed Thereon By Using Resist Upper Layer Film Materials (ArFPR1 to 14 and Comparative ArFPR)]

Using a coater/developer "CLEAN TRACK LITHIUS Pro AP" of Tokyo Electron Ltd., each of the resist upper layer film materials (ArFPR1 to 14 and comparative ArFPR) prepared above was respectively discharged in an amount of 2 ml onto a silicon wafer at the center. The material was spread by rotating the wafer at a rotational rate to achieve an average film thickness of 100 nm after baking. Next, the silicon wafer coated with the resist upper layer film was heated at 105°C for 60 seconds to obtain a silicon wafer having a resist upper layer film formed thereon.

### [In-Plane Uniformity Evaluation of Resist Upper Layer Films: Examples 4-1 to 4-14 and Comparative Example 4-1]

The film thickness within a radius of 145 mm from the center of each of resist upper layer films (ArFPR1 to 14 and comparative ArFPR) respectively formed on a silicon wafer according to the above-described method was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 3%, the material was evaluated as "Good", and when 3% or more, "Poor".

**[Table 11]**

| | Resist upper layer film material | In-plane uniformity |
|---|---|---|
| Example 4-1 | ArFPR1 | Good |
| Example 4-2 | ArFPR2 | Good |
| Example 4-3 | ArFPR3 | Good |
| Example 4-4 | ArFPR4 | Good |
| Example 4-5 | ArFPR5 | Good |
| Example 4-6 | ArFPR6 | Good |
| Example 4-7 | ArFPR7 | Good |
| Example 4-8 | ArFPR8 | Good |
| Example 4-9 | ArFPR9 | Good |
| Example 4-10 | ArFPR10 | Good |
| Example 4-11 | ArFPR11 | Good |
| Example 4-12 | ArFPR12 | Good |
| Example 4-13 | ArFPR13 | Good |
| Example 4-14 | ArFPR14 | Good |
| Comparative Example 4-1 | Comparative ArFPR | Poor |

As shown in Table 11, it can be observed that, since the resist upper layer film materials (ArFPR1 to 14) of the present invention were excellent in in-plane uniformity, the polymer (B) of the present invention functions as a surfactant that can impart an excellent leveling property, and can be contained in various compositions for forming an organic film regardless of the type of the resin to be combined with.

### [Preparation of Silicon-Containing Resist Middle Layer Film Materials (SOG3 to 16)]

Each of silicon-containing resist middle layer film materials (SOG3 to 16) was prepared by dissolving a polymer (SP1), a crosslinking catalyst (TMPANO₃), and maleic acid in an organic solvent (PGEE) and water in the proportions of Table 12, and filtering the mixture through a 0.1-µm filter made of a fluororesin.

The polymer (SP1) is shown below.

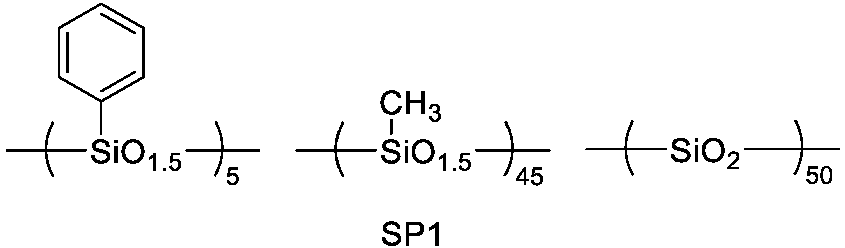

### TMPANO₃: trimethylphenylammonium nitrate

### PGEE: propylene glycol ethyl ether

**[Table 12]**

| Silicon-containing resist middle layer film material | Polymer (parts by mass) | Crosslinking catalyst (parts by mass) | Acid (parts by mass) | Compound (parts by mass) | Organic solvent (parts by mass) | Water (parts by mass) |
|---|---|---|---|---|---|---|
| SOG3 | SP1 (100) | TMPANO₃ (1.0) | Maleic acid (1.0) | (A1) (1.0) | PGEE (44100) | Water (4900) |
| SOG4 | SP1 (100) | TMPANO₃ (1.0) | Maleic acid (1.0) | (A2) (1.0) | PGEE (44100) | Water (4900) |
| SOG5 | SP1 (100) | TMPANO₃ (1.0) | Maleic acid (1.0) | (A3) (1.0) | PGEE (44100) | Water (4900) |
| SOG6 | SP1 (100) | TMPANO₃ (1.0) | Maleic acid (1.0) | (A4) (1.0) | PGEE (44100) | Water (4900) |
| SOG7 | SP1 (100) | TMPANO₃ (1.0) | Maleic acid (1.0) | (A5) (1.0) | PGEE (44100) | Water (4900) |
| SOG8 | SP1 (100) | TMPANO₃ (1.0) | Maleic acid (1.0) | (A6) (1.0) | PGEE (44100) | Water (4900) |
| SOG9 | SP1 (100) | TMPANO₃ (1.0) | Maleic acid (1.0) | (A7) (1.0) | PGEE (44100) | Water (4900) |
| SOG10 | SP1 (100) | TMPANO₃ (1.0) | Maleic acid (1.0) | (A8) (1.0) | PGEE (44100) | Water (4900) |
| SOG11 | SP1 (100) | TMPANO₃ (1.0) | Maleic acid (1.0) | (A9) (1.0) | PGEE (44100) | Water (4900) |
| SOG12 | SP1 (100) | TMPANO₃ (1.0) | Maleic acid (1.0) | (A10) (1.0) | PGEE (44100) | Water (4900) |
| SOG13 | SP1 (100) | TMPANO₃ (1.0) | Maleic acid (1.0) | (A11) (1.0) | PGEE (44100) | Water (4900) |
| SOG14 | SP1 (100) | TMPANO₃ (1.0) | Maleic acid (1.0) | (A12) (1.0) | PGEE (44100) | Water (4900) |
| SOG15 | SP1 (100) | TMPANO₃ (1.0) | Maleic acid (1.0) | (A13) (1.0) | PGEE (44100) | Water (4900) |
| SOG16 | SP1 (100) | TMPANO₃ (1.0) | Maleic acid (1.0) | (A14) (1.0) | PGEE (44100) | Water (4900) |

### [Silicon-Containing Resist Middle Layer Film Coating Property Evaluation: Examples 5-1 to 5-14 and Comparative Example 5-1]

A cured organic film was formed by using the composition (comparative UDL-1) for forming an organic film on a silicon wafer substrate according to the above-described method. Each of the silicon-containing resist middle layer film materials (SOG1, 3 to 16) shown below was applied thereto, and baking was performed at 200°C for 60 seconds to form a silicon-containing resist middle layer film. Then, the condition of the coating film of the silicon-containing resist middle layer film was visually observed and evaluated.

When the condition of the coating film was good, the composition was evaluated as "Good", and when dewetting had occurred, as "Poor".

Note that, in this evaluation, to evaluate whether the coatability of the silicon-containing resist middle layer film is excellent or not, the thickness of the silicon-containing resist middle layer film was set to 5 nm, and this is a special, severe evaluation condition.

**[Table 13]**

| | Silicon-containing resist middle layer film material | Silicon-containing resist middle layer film coating property evaluation |
|---|---|---|
| Example 5-1 | SOG3 | Good |
| Example 5-2 | SOG4 | Good |
| Example 5-3 | SOG5 | Good |
| Example 5-4 | SOG6 | Good |
| Example 5-5 | SOG7 | Good |
| Example 5-6 | SOG8 | Good |
| Example 5-7 | SOG9 | Good |
| Example 5-8 | SOG10 | Good |
| Example 5-9 | SOG11 | Good |
| Example 5-10 | SOG12 | Good |
| Example 5-11 | SOG13 | Good |
| Example 5-12 | SOG14 | Good |
| Example 5-13 | SOG15 | Good |
| Example 5-14 | SOG16 | Good |
| Comparative Example 5-1 | SOG1 | Poor |

As shown in Table 13, regarding silicon-containing resist middle layer film materials (SOG3 to 16), dewetting did not occur, and film-formability was excellent. From this fact, it is revealed that the inventive polymer (B) can be applied to and used for various compositions for forming a film as a surfactant for allowing high film-formability to be exhibited and so forth.

From the above, the inventive composition for forming an organic film has excellent film-formability, high filling property, hump suppression property, and an excellent coating property of silicon-containing middle layer films, and therefore, is extremely useful as an organic film material used in a multilayer resist process. Furthermore, the inventive patterning processes, using the inventive composition for forming an organic film, make it possible to fill holes and trenches having very high aspect ratios without gaps, form a fine pattern with high precision, and form a hump-suppressed organic film, and therefore, make it possible to manufacture semiconductor devices and the like efficiently.

The present description includes the following inventions.
[1]: A composition for forming an organic film, comprising: a resin and/or compound (A) for forming an organic film; a polymer (B) not containing a halogen atom and containing a repeating unit represented by the following formula (1) and a repeating unit represented by the following formula (1'); and a solvent (C), 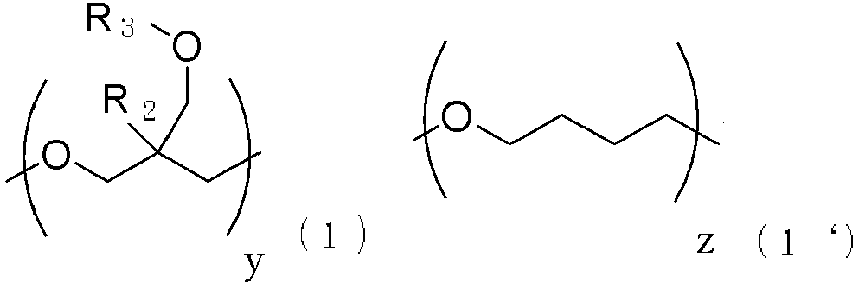 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.
[2]: The composition for forming an organic film according to [1], wherein the polymer (B) is represented by the following formula (2), 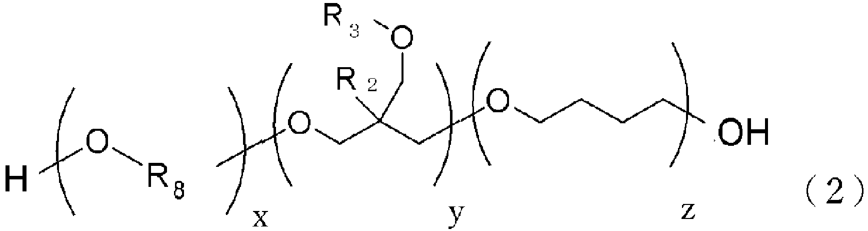 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.
[3]: The composition for forming an organic film according to [2], wherein, in the polymer represented by the formula (2), the "x", "y", and "z" in the formula each independently satisfy 0 < x < 1, 0 < y < 1, and 0 < z < 1, provided that x+y+z = 1.
[4]: The composition for forming an organic film according to [1], wherein the polymer (B) is represented by the following formula (3), 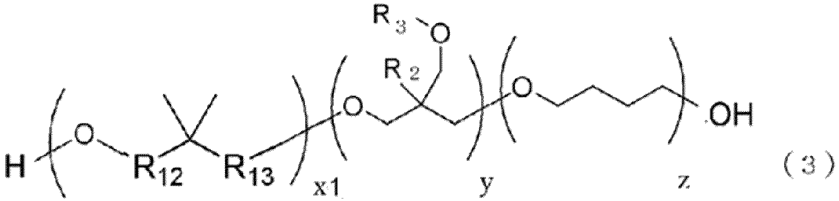 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.
[5]: The composition for forming an organic film according to [2], wherein the "x", "y", and "z" in the general formula (2) satisfy x+y+z = 1, z < x < y, and z+x < y.
[6]: The composition for forming an organic film according to any one of [1] to [5], wherein the polymer (B) has a weight-average molecular weight of 1000 to 30000.
[7]: The composition for forming an organic film according to any one of [1] to [6], wherein the polymer (B) is contained in an amount of 0.01 parts by mass to 5 parts by mass based on 100 parts by mass of the resin and/or compound (A) for forming an organic film.
[8]: A method for manufacturing a polymer not containing a halogen atom and containing a repeating unit represented by the following formula (1) and a repeating unit represented by the following formula (1'), the method comprising ring-opening polymerization of an oxetane-ring-containing compound represented by the following formula (4), using a Lewis acid cationic polymerization catalyst and tetrahydrofuran, 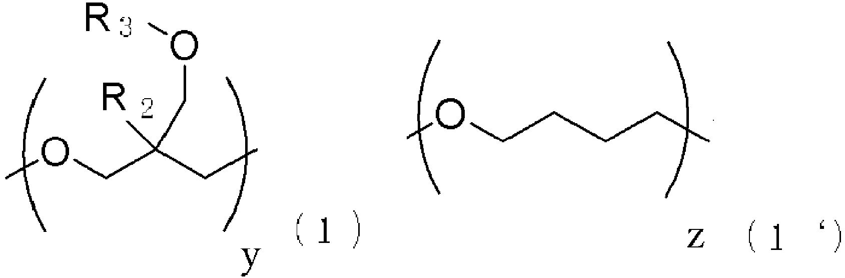 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1, 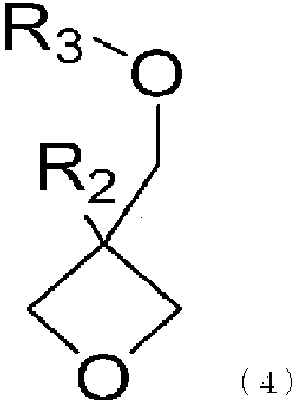 wherein R₂ and R₃ are as defined in the formula (1).
[9]: A method for forming an organic film to be used in a manufacturing process of a semiconductor device, the method comprising:
   spin-coating a substrate to be processed with the composition for forming an organic film according to any one of [1] to [7]; and
   forming a cured film by heating the substrate coated with the composition for forming an organic film at a temperature of 100°C or higher and 600°C or lower for 10 to 600 seconds.
[10]: A patterning process comprising:
   forming an organic film on a body to be processed by using the composition for forming an organic film according to any one of [1] to [7];
   forming a resist middle layer film on the organic film by using a resist middle layer film material containing a silicon atom;
   forming a resist upper layer film on the resist middle layer film by using a resist upper layer film material comprising a photoresist composition;
   forming a circuit pattern in the resist upper layer film;
   transferring the pattern to the resist middle layer film by etching while using the resist upper layer film having the formed circuit pattern as a mask;
   transferring the pattern to the organic film by etching while using the resist middle layer film having the transferred pattern as a mask; and
   further transferring the pattern to the body to be processed by etching while using the organic film having the transferred pattern as a mask.
[11]: A patterning process comprising:
   forming an organic film on a body to be processed by using the composition for forming an organic film according to any one of [1] to [7];
   forming a resist middle layer film on the organic film by using a resist middle layer film material containing a silicon atom;
   forming an organic antireflective film or an adhesive film on the resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the resist middle layer film by etching while using the resist upper layer film having the formed circuit pattern as a mask;
   transferring the pattern to the organic film by etching while using the resist middle layer film having the transferred pattern as a mask; and
   further transferring the pattern to the body to be processed by etching while using the organic film having the transferred pattern as a mask.
[12]: A patterning process comprising:
   forming an organic film on a body to be processed by using the composition for forming an organic film according to any one of [1] to [7];
   forming an inorganic hard mask selected from the group consisting of a silicon oxide film, a silicon nitride film, and a silicon oxynitride film on the organic film;
   forming a resist upper layer film on the inorganic hard mask by using a resist upper layer film material comprising a photoresist composition;
   forming a circuit pattern in the resist upper layer film;
   transferring the pattern to the inorganic hard mask by etching while using the resist upper layer film having the formed circuit pattern as a mask;
   transferring the pattern to the organic film by etching while using the inorganic hard mask having the transferred pattern as a mask; and
   further transferring the pattern to the body to be processed by etching while using the organic film having the transferred pattern as a mask.
[13]: A patterning process comprising:
   forming an organic film on a body to be processed by using the composition for forming an organic film according to any one of [1] to [7];
   forming an inorganic hard mask selected from the group consisting of a silicon oxide film, a silicon nitride film, and a silicon oxynitride film on the organic film;
   forming an organic antireflective film or an adhesive film on the inorganic hard mask;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the inorganic hard mask by etching while using the resist upper layer film having the formed circuit pattern as a mask;
   transferring the pattern to the organic film by etching while using the inorganic hard mask having the transferred pattern as a mask; and
   further transferring the pattern to the body to be processed by etching while using the organic film having the transferred pattern as a mask.
[14]: The patterning process according to [12] or [13], wherein the inorganic hard mask is formed by a CVD method or an ALD method.
[15]: The patterning process according to any one of [10] to [14], wherein the circuit pattern is formed by a lithography using light having a wavelength of 10 nm or more and 300 nm or less, a direct writing with electron beam, nanoimprinting, or a combination thereof.
[16]: The patterning process according to any one of [10] to [15], wherein the circuit pattern is developed with an alkaline development or an organic solvent.
[17]: The patterning process according to any one of [10] to [16], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[18]: The patterning process according to [17], wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
[19]: A polymer for a composition for forming an organic film, the polymer not containing a halogen atom and containing a repeating unit represented by the following formula (1) and a repeating unit represented by the following formula (1'), 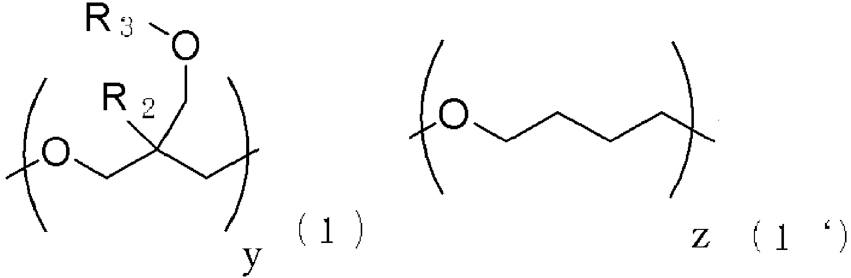 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.
[20]: The polymer for a composition for forming an organic film according to [19], wherein the polymer is represented by the following formula (2), 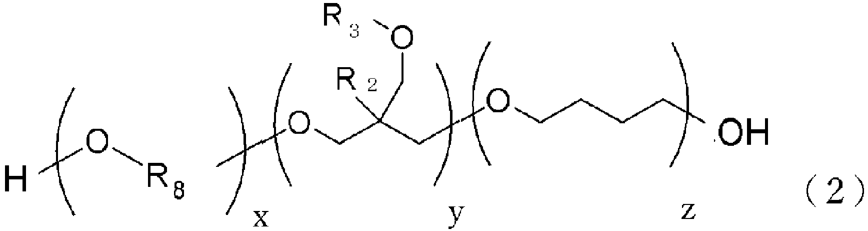 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.
[21]: The polymer for a composition for forming an organic film according to [19], wherein the polymer is represented by the following formula (3), 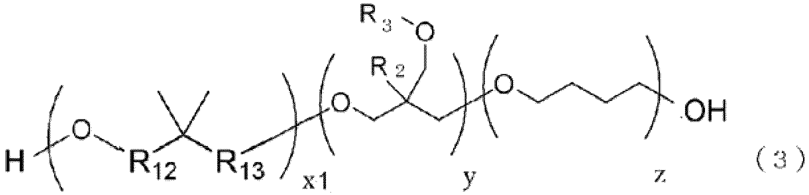 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.
[22]: The polymer for a composition for forming an organic film according to [20], wherein the "x", "y", and "z" in the general formula (2) satisfy x+y+z = 1, z < x < y, and z+x < y.
[23]: The polymer for a composition for forming an organic film according to any one of [19] to [21], wherein the polymer has a weight-average molecular weight of 1000 to 30000.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising: a resin and/or compound (A) for forming an organic film; a polymer (B) not containing a halogen atom and containing a repeating unit represented by the following formula (1) and a repeating unit represented by the following formula (1'); and a solvent (C), 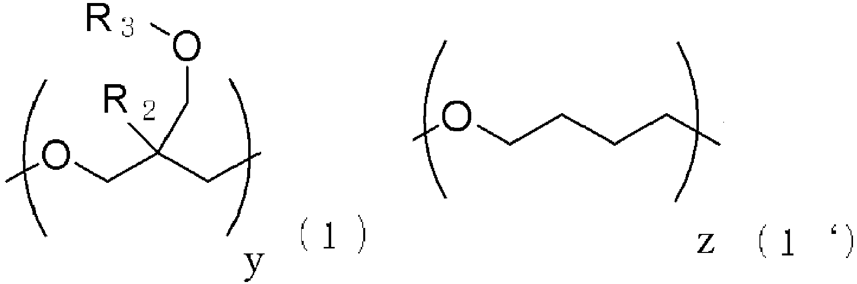 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.

2. The composition for forming an organic film according to claim 1, wherein the polymer (B) is represented by the following formula (2), 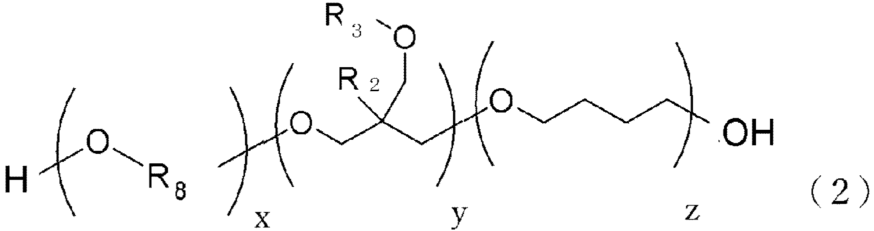 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1, preferably wherein
in the polymer represented by the formula (2), the "x", "y", and "z" in the formula each independently satisfy 0 < x < 1, 0 < y < 1, and 0 < z < 1, provided that x+y+z = 1.

3. The composition for forming an organic film according to claim 1, wherein the polymer (B) is represented by the following formula (3), 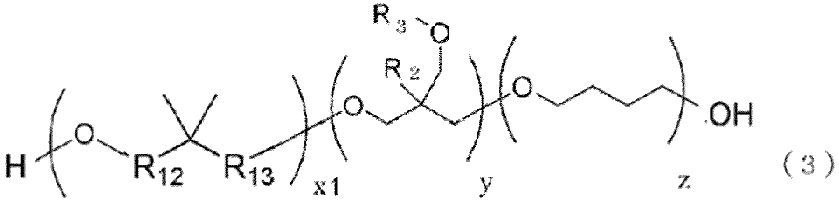 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.

4. The composition for forming an organic film according to claim 2, wherein the "x", "y", and "z" in the general formula (2) satisfy x+y+z = 1, z < x < y, and z+x < y.

5. The composition for forming an organic film according to claim 1, wherein the polymer (B) has a weight-average molecular weight of 1000 to 30000, and/or wherein the polymer (B) is contained in an amount of 0.01 parts by mass to 5 parts by mass based on 100 parts by mass of the resin and/or compound (A) for forming an organic film.

6. A method for manufacturing a polymer not containing a halogen atom and containing a repeating unit represented by the following formula (1) and a repeating unit represented by the following formula (1'), the method comprising ring-opening polymerization of an oxetane-ring-containing compound represented by the following formula (4), using a Lewis acid cationic polymerization catalyst and tetrahydrofuran, 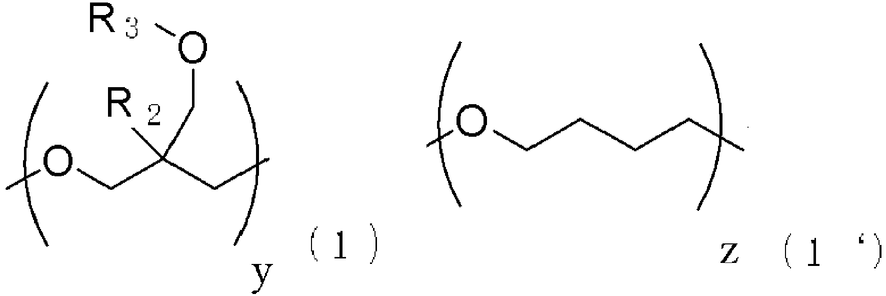 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1, 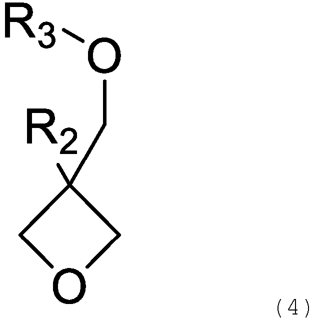 wherein R₂ and R₃ are as defined in the formula (1).

7. A method for forming an organic film to be used in a manufacturing process of a semiconductor device, the method comprising:
spin-coating a substrate to be processed with the composition for forming an organic film according to any one of claims 1 to 5; and
forming a cured film by heating the substrate coated with the composition for forming an organic film at a temperature of 100°C or higher and 600°C or lower for 10 to 600 seconds.

8. A patterning process comprising:
forming an organic film on a body to be processed by using the composition for forming an organic film according to any one of claims 1 to 5;
forming a resist middle layer film on the organic film by using a resist middle layer film material containing a silicon atom;
forming a resist upper layer film on the resist middle layer film by using a resist upper layer film material comprising a photoresist composition;
forming a circuit pattern in the resist upper layer film;
transferring the pattern to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask, or
a patterning process comprising:
forming an organic film on a body to be processed by using the composition for forming an organic film according to any one of claims 1 to 5;
forming a resist middle layer film on the organic film by using a resist middle layer film material containing a silicon atom;
forming an organic antireflective film or an adhesive film on the resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the resist middle layer film by etching while using the resist upper layer film having the formed circuit pattern as a mask;
transferring the pattern to the organic film by etching while using the resist middle layer film having the transferred pattern as a mask; and
further transferring the pattern to the body to be processed by etching while using the organic film having the transferred pattern as a mask, or
a patterning process comprising:
forming an organic film on a body to be processed by using the composition for forming an organic film according to any one of claims 1 to 5;
forming an inorganic hard mask selected from the group consisting of a silicon oxide film, a silicon nitride film, and a silicon oxynitride film on the organic film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask, preferably wherein
the inorganic hard mask is formed by a CVD method or an ALD method, or
a patterning process comprising:
forming an organic film on a body to be processed by using the composition for forming an organic film according to any one of claims 1 to 5;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask, preferably wherein
the inorganic hard mask is formed by a CVD method or an ALD method.

9. The patterning process according to claim 8, wherein the circuit pattern is formed by a lithography using light having a wavelength of 10 nm or more and 300 nm or less, a direct writing with electron beam, nanoimprinting, or a combination thereof, and/or,
wherein the circuit pattern is developed with an alkaline development or an organic solvent.

10. The patterning process according to claims 8 to 9, wherein the body to be processed is a semiconductor device substrate or the semiconductor device substrate coated with any of a metal film, a metal carbide film, a metal oxide film, a metal nitride film, a metal oxycarbide film, and a metal oxynitride film, prefarably wherein
the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

11. A polymer for a composition for forming an organic film, the polymer not containing a halogen atom and containing a repeating unit represented by the following formula (1) and a repeating unit represented by the following formula (1'), 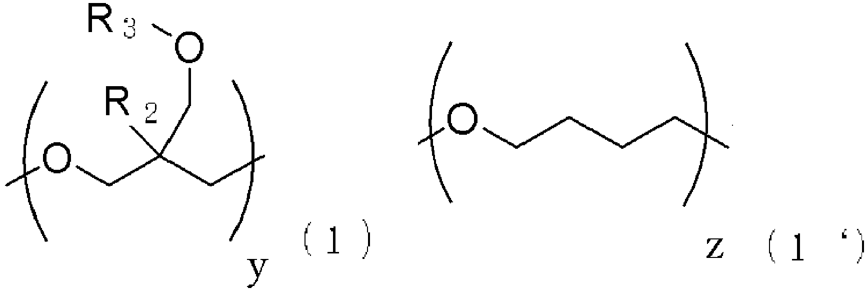 wherein R₂ and R₃ each independently represent a saturated or unsaturated organic group having 1 to 20 carbon atoms and optionally having a substituent, and "y" and "z" each independently satisfy 0 < y < 1 and 0 < z < 1, provided that y+z = 1.

12. The polymer for a composition for forming an organic film according to claim 11, wherein the polymer is represented by the following formula (2), 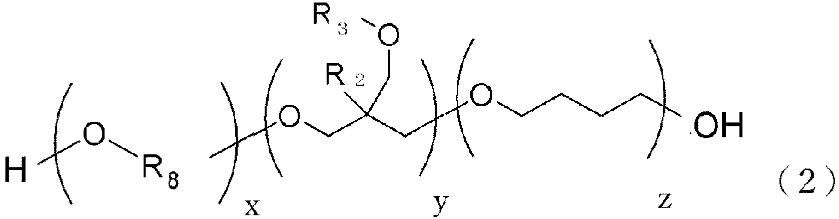 wherein R₂ and R₃ are as defined in the formula (1); R₈ represents a saturated or unsaturated organic group having 1 to 20 carbon atoms and optionally having a substituent; and "x", "y", and "z" each independently satisfy 0 ≤ x < 1, 0 < y < 1, and 0 < z < 1, provided that x+y+z = 1.

13. The polymer for a composition for forming an organic film according to claim 11, wherein the polymer is represented by the following formula (3), 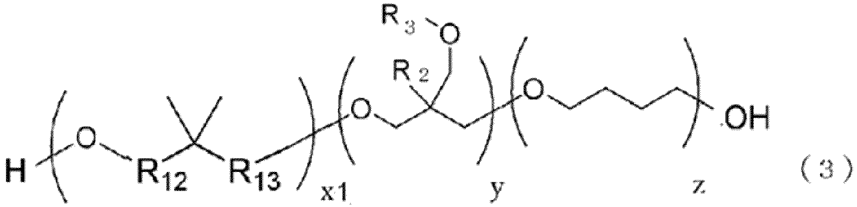 wherein R₂ and R₃ are as defined above; R₁₂ and R₁₃ each represent a saturated or unsaturated divalent organic group having 1 to 16 carbon atoms and optionally having a substituent; and "x1", "y", and "z" each independently satisfy 0 < x1 < 1, 0 < y < 1, and 0 < z < 1, provided that x1+y+z = 1.

14. The polymer for a composition for forming an organic film according to claim 12, wherein the "x", "y", and "z" in the general formula (2) satisfy x+y+z = 1, z < x < y, and z+x < y.

15. The polymer for a composition for forming an organic film according to claims 11 to 13, wherein the polymer has a weight-average molecular weight of 1000 to 30000.
